# EUROPEAN PATENT SPECIFICATION

(11) **EP 4 687 024 B1**
(45) Date of publication and mention of the grant of the patent: **18.11.2026**
(21) Application number: 25190395.1
(22) Date of filing: 18.07.2025
(51) Int. Cl.: G06F 7/544

(54) **IN-MEMORY COMPUTATION DEVICE HAVING IMPROVED MAPPING OF COMPUTATION WEIGHTS**
SPEICHERINTERNE BERECHNUNGSVORRICHTUNG MIT VERBESSERTER ABBILDUNG VON BERECHNUNGSGEWICHTEN
DISPOSITIF DE CALCUL EN MÉMOIRE AYANT UNE MISE EN CORRESPONDANCE AMÉLIORÉE DE POIDS DE CALCUL

(30) Priority: 30.07.2024 IT 202400017671
(43) Date of publication of application: 04.02.2026
(73) Proprietor: STMicroelectronics International N.V., 1228 Plan-les-Ouates, Geneva (CH)
(72) Inventor: ZURLA, Riccardo, 20082 BINASCO (MI) (IT); PASOTTI, Marco, 27020 TRAVACÒ SICCOMARIO (PV) (IT); CALVETTI, Emanuela, 24030 VILLA D'ADDA (BG) (IT); BERTOLINI AGNOLETTO, Jacopo John, 20136 MILANO (IT)
(74) Representative: Studio Torta S.p.A.

(56) References cited:
- EP-A1- 4 390 935
- US-A1- 2019 043 560
- US-A1- 20240 086 696
- US-B2- 11 531 898

## Description

### Technical Field

The present invention relates to an In-Memory Computation (IMC) device, in particular for performing a MAC (multiply and accumulate) operation, having improved mapping of computation weights. Furthermore, the invention also refers to a control method of the IMC device.

### Background

As is known, an in-memory computation device (hereinafter IMC device) uses the specific arrangement of the memory cells of a memory array to perform analog processing of data.

For example, IMC devices are used to perform multiply and accumulate (MAC) operations, which are used for example to implement machine learning algorithms, such as neural networks.

A multiply and accumulate operation provides an output vector Y=y₁,...,y_{M} as a result of multiplying an input vector X=x₁,...,x_{N} by a computation weight vector or matrix G, for example: $\left[\begin{matrix}{y}_{1} \\ {y}_{2} \\ ⋮ \\ {y}_{m}\end{matrix}\right] = \left[\begin{matrix}{g}_{11} & {g}_{12} & ⋯ & {g}_{1 n} \\ {g}_{21} & {g}_{22} & ⋯ & {g}_{2 n} \\ ⋮ & ⋮ & ⋮ & ⋮ \\ {g}_{m 1} & {g}_{m 2} & ⋯ & {g}_{mn}\end{matrix}\right] \times \left[\begin{matrix}{x}_{1} \\ {x}_{2} \\ ⋮ \\ {x}_{n}\end{matrix}\right] , i . e . :$ $\left\{\begin{matrix}{y}_{1} = {g}_{11} ⋅ {x}_{1} + {g}_{12} ⋅ {x}_{2} + ⋯ + {g}_{1 N} ⋅ {x}_{N} \\ {y}_{2} = {g}_{21} ⋅ {x}_{1} + {g}_{22} ⋅ {x}_{2} + ⋯ + {g}_{2 N} ⋅ {x}_{N} \\ ⋮ \\ {y}_{M} = {g}_{M 1} ⋅ {x}_{1} + {g}_{M 2} ⋅ {x}_{2} + ⋯ + {g}_{MN} ⋅ {x}_{N}\end{matrix}\right. .$

The IMC device stores the computation weights gᵢⱼ in the memory cells and performs the multiplication and addition operations at the cell level.

In detail, for each value yᵢ of the output vector Y, known IMC devices generate a current indicative of a respective MAC operation, i.e. ${y}_{i} = {\sum }_{i = 1}^{i = M} {g}_{ij} ⋅ {x}_{j}$*,* and comprise a read circuit having a respective analog-to-digital converter (ADC) which discretizes said current.

IMC devices allow avoiding the back-and-forth transfer of data between a memory and a processing unit. As a result, the performance of an IMC device is not limited by the data transfer bandwidth between memory and processing unit and has low power consumption.

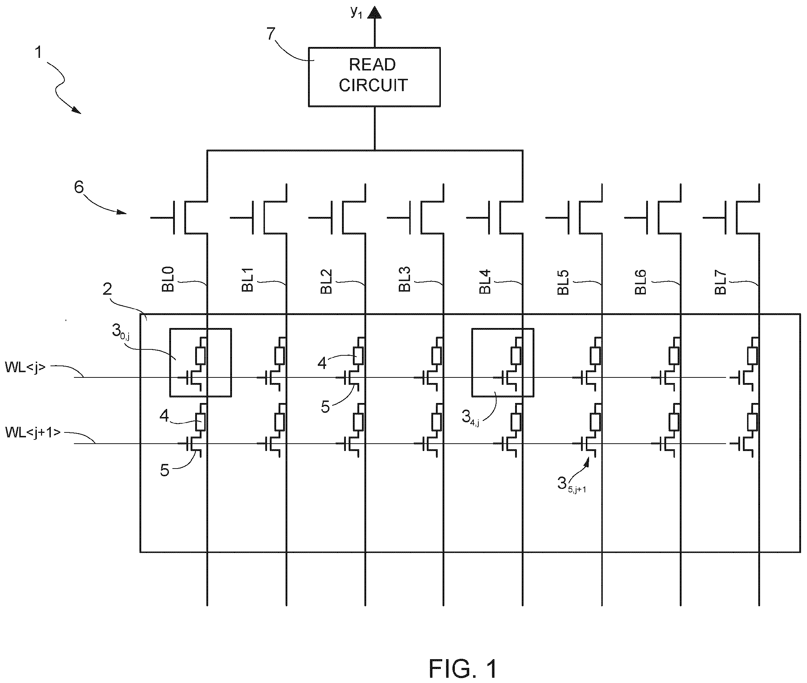

Figure 1 shows a known IMC device 1 comprising a memory array 2 having a plurality of memory cells 3_{l,j}, each coupled to a respective word line WLⱼ and a respective bit line BLₗ.

In the example of Figure 1, two word lines WL<j>, WL<j+1> and eight bit lines, l=0 to l=7, of the memory array 2 are shown.

Each memory cell 3_{l,j} comprises a resistive element 4 and a selection element 5, arranged in series with each other.

The resistive element 4 may be programmed in such a way as to have one of 2^{N} resistance levels, where N is the number of bits of the memory cell 3_{l,j}.

The IMC device 1 further comprises a plurality of selection transistors 6, one for each bit line BL₁, and a read circuit 7 coupled to the bit lines BL₀ and BL₄.

In order to increase the processing accuracy of a MAC operation, there is a need to use computation weights g_{i,j} having a high number of bits.

According to one approach, each computation weight g_{i,j} may be mapped in a single cell of the memory array. In this case, the memory cells 3_{l,j} need to be designed to have a high number of bits (and therefore consequently a high number of resistance levels). However, it is technologically complicated to manufacture memory cells having a high number of bits, for example higher than 4 bits.

According to another approach, each computation weight g_{i,j} may be mapped in the memory array 2 using two memory cells.

For example, with reference to Figure 1, the computation weight g_{1,j} is mapped using the memory cells 3_{0,j} and 3_{4,j}.

In this case, according to one approach, the memory cells 3_{0,j} and 3_{4,j} are activated simultaneously within a same computation window, for a same duration which is a function of the respective input value xⱼ associated with the word line WL<j>.

In the computation window, the memory cells 3_{0,j} and 3_{4,j} are each traversed by a respective current having the same duration (equal to the activation duration) and magnitude which is a function of the respective programmed resistance level.

Furthermore, within the processing window, the read circuit 7 simultaneously integrates both the current that flows in the bit line BL₀ and the current that flows in the bit line BL₄.

This processing method allows to obtain, for the computation of the MAC operation, the computation weight g_{i,j} having an effective number of bits greater than the number of bits of the two single memory cells (3_{0,j} and 3_{4,j}) used to map the same computation weight g_{1,j}.

For example, in case the number of bits of each memory cell is N=1 (and therefore each memory cell 3_{l,j} has a number of resistance levels equal to 2), the IMC device 1 allows to obtain the computation weight g_{i,j} as if it were stored by an actual memory cell having a number of resistance levels equal to 3 (therefore approximately 1.5 bits).

In case the number of bits of each memory cell is N=4 (and therefore each memory cell 3_{l,j} has a number of resistance levels equal to 16), the IMC device 1 allows to obtain the computation weight g_{i,j} as if it were mapped by an actual memory cell having a number of resistance levels equal to 31 (therefore as if it had approximately 5 bits).

The known approaches therefore have a low efficiency in mapping computation weights having a high number of bits.

The aim of the present invention is to overcome the disadvantages of the prior art.

### Summary

According to the present invention, an in-memory computation device and a control method are thus provided, as defined in the appended claims.

### Brief Description of the Drawings

For a better understanding of the present invention, embodiments thereof are now described, purely by way of nonlimiting example, with reference to the attached drawings, wherein:
- Figure 1 shows a simplified block diagram of a known in-memory computation device;
- Figure 2 shows a block diagram of an in-memory computation device, according to one embodiment;
- Figure 3 shows an enlarged portion of a group of memory cell of the device of Figure 2;
- Figure 4 shows a block diagram of a word line activation circuit of the device of Figure 2, according to one embodiment;
- Figure 5 shows a block diagram of a digital detector of the device of Figure 2, according to one embodiment;
- Figure 6 shows exemplary waveforms of a method for performing a MAC operation by the device of Figure 2, according to one embodiment;
- Figure 7 shows exemplary waveforms of a method for performing a MAC operation by the device of Figure 2, according to a different embodiment;
- Figure 8 shows exemplary waveforms of a method for performing a MAC operation by the device of Figure 2, according to a further embodiment;
- Figure 9 shows an exemplary diagram of a mapping of computation weights obtainable by the device of Figure 2, according to one embodiment;
- Figure 10 shows a circuit diagram of an integrator of the digital detector of the device of Figure 2, according to one embodiment;
- Figure 11 shows a circuit diagram of a counting stage of the digital detector of the device of Figure 2, according to one embodiment; and
- Figures 12 and 13 show exemplary diagrams of a mapping of computation weights obtainable by the device of Figure 2, according to further embodiments.

### Description of Embodiments

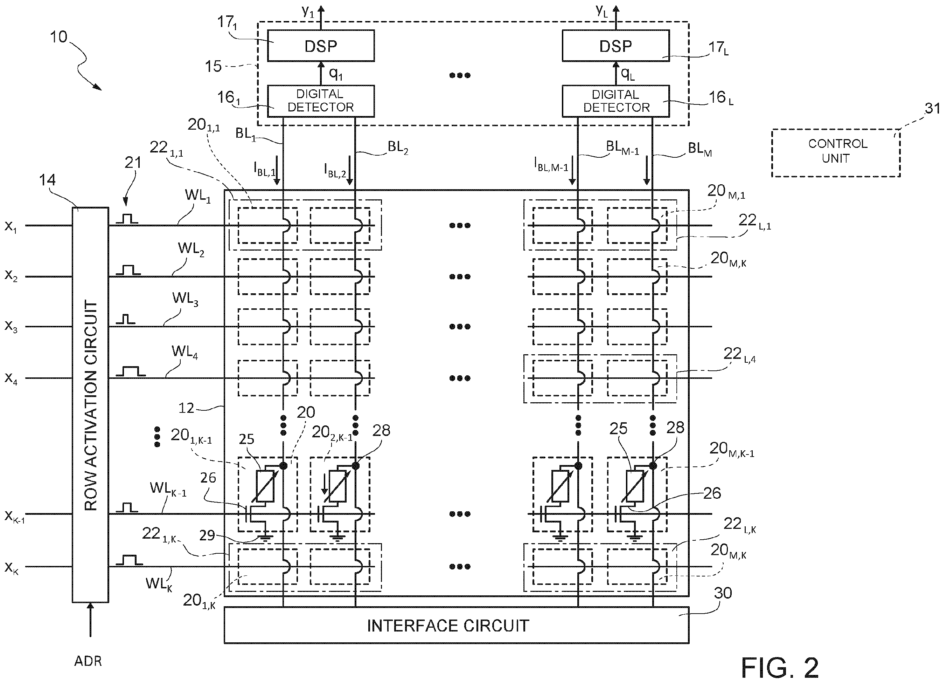

Figure 2 shows an in-memory computation device (hereinafter IMC device) 10 comprising a memory array (or matrix) 12, a word line activation unit or circuit 14, and a read unit or circuit 15 comprising herein a plurality of digital detectors 16 and digital processors, DSP, 17.

The memory array 12 comprises a plurality of memory cells 20 organized according to a matrix arrangement having M columns and K rows.

In particular, in this embodiment, the memory cells 20 are of the non-volatile type.

The IMC device 10 is configured to perform an in-memory operation, in particular a Multiply and Accumulate (MAC) operation between an input vector (or signal) X having input data x₁,...,x_{J} (in general, with J≤K and in particular in the embodiment of Figure 2 with J=K) and a plurality of computation weights G, in order to generate an output vector (or signal) Y having output data y₁,...,y_{L} (in general, with L≤M and, in particular in the embodiment of Figure 2, with L=M/2).

The memory cells 20 arranged in the same column are mutually connected through a respective bit line BLₘ, where m=1,...,M. The memory cells 20 arranged in the same row are mutually connected through a respective word line WLⱼ, where j=1,...,K.

In practice, a respective word line WLⱼ and a respective bit line BLₘ are associated with each memory cell 20.

Therefore, hereinafter, a generic memory cell of the plurality of memory cells 20 is identified by 20_{m,j}, where the indices m=1,...,M and j=1,...,K indicate the column and, respectively, the row of the generic memory cell in the memory array 12.

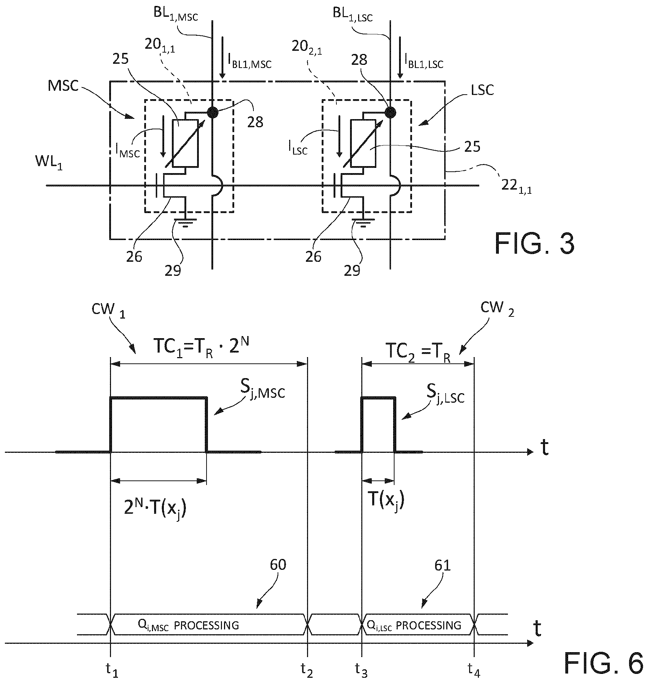

The memory cells 20 are further organized so as to form a plurality of groups of memory cells, where each group of memory cells is indicated hereinafter by 22_{i,j} and identified by a dash-dot line in Figure 2 and in the respective enlarged portion of Figure 3. Hereinafter, the plurality of groups of memory cells 22_{i,j} may also be indicated as a whole by the reference number 22.

Each group of memory cells 22_{i,j} is configured to store a respective computation weight Gᵢⱼ that may be used to perform the MAC operation.

Each group of memory cells 22_{i,j} comprises at least a first memory cell and a second memory cell. The first memory cell and the second memory cell may be coupled to a first and a second word line (for example corresponding to a same word line or to two word lines distinct from each other) and to a first and a second bit line.

In detail, with reference to the enlarged portion of Figure 3, in this embodiment each group of memory cells 22_{i,j} comprises a respective Most Significant Cell, MSC, and a respective Least Significant Cell, LSC, that belong to the plurality of memory cells 20.

In the arrangement of Figures 2 and 3, the most significant cell MSC and the least significant cell LSC of each group of cells 22_{i,j} are coupled to a same word line WLⱼ and to two adjacent bit lines BLₘ₋₁, BLₘ.

For example, the word line WLⱼ having the most significant cell MSC and the least significant cell LSC coupled thereto may also be indicated as the first word line.

In practice, in this embodiment, the plurality of groups of memory cells 22 also forms a matrix having L columns and K rows, where L=M/2.

In detail, the plurality of groups of memory cells 22 comprises the groups of memory cells 22_{i,j}, where the indices i=1,...,L and j=1,...,K indicate the column and, respectively, the row of the generic group of cells 22_{i,j}.

A most significant bit line BL_{i,MSC}, i.e. the bit line having the respective most significant cell MSC coupled thereto, and a least significant bit line BL_{i,LSC}, i.e. the bit line having the respective least significant cell LSC coupled thereto, are therefore associated with each group of memory cells 22_{i,j}.

In the example of Figures 2 and 3, the most significant cell MSC of the group of memory cells 22_{1,1} corresponds to the memory cell 20_{1,1} and is therefore coupled to the bit line BL₁, which hereinafter will also be identified as BL_{1,MSC}; and the least significant cell LSC of the group of memory cells 22_{1,1} corresponds to the memory cell 20_{2,1} and is therefore coupled to the bit line BL₂, which hereinafter will also be identified as BL_{1,LSC}.

In practice, in the exemplary configuration of Figure 2, all the memory cells 20_{1,1},...,20_{1,K} that are coupled to the bit line BL₁ each form the most significant cell MSC of the respective group of memory cells 22_{1,1},...,22_{1,K}; and all memory cells 20_{2,1},...,20_{2,K} that are coupled to the bit line BL₂ each form the least significant cell LSC of the respective group of memory cells 22_{1,1},...,22_{1,K}.

Again by way of example, all memory cells 20_{M-1,1},...,20_{M-1,K} that are coupled to the bit line BL_{M-1} each form the most significant cell MSC of the respective group of memory cells 22_{L,1},...,22_{L,K}; and all memory cells 20_{M,1},...,20_{M,K} that are coupled to the bit line BL_{M} each form the least significant cell LSC of the respective group of memory cells 22_{L,1},...,22_{L,K}.

The memory cells 20 each comprise a storage element 25 and a selection element 26.

The storage element 25 of each memory cell 20_{l,j} is a variable resistive element that may be programmed in such a way as to have a specific resistance value (or level).

In detail, each memory cell 20_{l,j} is configured to be programmed in one of 2^{N} resistance levels, where N is the number of bits of the memory cell 20_{l,j}.

For simplicity of description, hereinafter it will be considered that all the memory cells 20 have the same number of bits N. However, the memory cells 20 may have a number of bits different from each other.

Considering a generic group of memory cells 22_{i,j}, the resistance R_{i,MSC} of the storage element 25 of the respective most significant cell MSC and the resistance R_{i,LSC} of the storage element 25 of the respective least significant cell LSC are programmed as a function of the weight Gᵢⱼ that is desired to be mapped in the generic group of cells 22_{i,j}.

In detail, taking into consideration a 2N-bit binary representation of a generic computation weight Gᵢⱼ, the storage element 25 of the most significant cell MSC of the respective group of memory cells 22_{i,j} may be programmed in such a way as to have a resistance level R_{i,MSC} which is a function of the N most significant bits of the computation weight Gᵢⱼ; and the storage element 25 of the least significant cell LSC of the respective group of memory cells 22_{i,j} may be programmed in such a way as to have a resistance level R_{i,LSC} which is a function of the N least significant bits of the computation weight Gᵢⱼ. However, more generally, the generic computation weight Gᵢⱼ may have a binary representation having N₁+N₂ bit, where N₁ may be the number of most significant bits and N₂ the number of least significant bits.

The resistance levels R_{i,MSC}, R_{i,LSC} of each group of memory cell 22_{i,j} may be associated with respective conductance levels g_{i,MSC}, g_{i,LSC} of the MSC and, respectively, LSC cells, where the conductance level is inversely proportional to the respective resistance level. The encoding of a weight on the conductance level may be linear increasing. In other words, the conductance level may be a linear increasing function of the absolute value of the weight.

In particular, the storage elements 25 of the memory cells 20 may be based on a Phase Change Material (PCM), such as for example a chalcogenide. In fact, a phase change material may have at least two phase states, for example an amorphous phase and a crystalline phase, each having a respective resistivity.

A phase change material may be transformed from one phase state to another by heat transfer, for example using current pulses.

The resistance of each storage element 25 associated with the respective phase state may be used to distinguish two or more logic states of the corresponding memory cell 20.

For example, the amorphous phase may have a higher resistance with respect to the crystalline phase. A logic state '0', or reset state, may be associated with the amorphous phase of the storage element 25. A logic state '1', or set state, may be associated with the crystalline phase of the storage element 25.

However, each storage element 25 may also be programmable in a higher number of states or levels.

The storage element 25 has a first terminal coupled to a node 28 of the respective bit line BL₁ and a second terminal coupled to a reference potential node, here to ground 29, through the selection element 26.

The selection element 26 is a switch, for example a BJT transistor, a diode or a MOS transistor, here an NMOS transistor, which is arranged in series with the respective storage element 25 and whose switching is controlled by an activation signal generated by the row activation circuit 14 and provided to the respective word line WLⱼ.

In this embodiment, the NMOS transistor forming the selection element 26 has a source coupled, here directly connected, to ground 29; a drain coupled, here directly connected, to the second terminal of the storage element 25; and a gate coupled, here directly connected, to the respective word line WLⱼ.

In practice, the storage element 25 and the selection element 26 form a current path of the respective memory cell 20_{l,j}; the selection element 26, in response to receiving the respective activation signal, closes the respective current path, thereby allowing a cell current i_{cell} to flow from the common node 28 to the ground 29.

The word line activation unit 14 receives the input vector X including the plurality of input values x₁,...,x_{K}, for example one for each word line WLⱼ, and provides a plurality of activation signals 21, for example at least one for each word line WL₁,...,WL_{K}.

The activation signals 21 are configured to each activate the memory cells 20 coupled to a respective word line WLⱼ, for a duration which is a function of at least the respective input datum xⱼ.

In detail, the activation signals 21 may be pulses, in particular here rectangular pulses, each having a duration which is a function of at least the respective input value xⱼ.

In fact, a time duration of value T(xⱼ) which is a function of the respective input value xⱼ may be associated with each input value xⱼ. In particular, the time duration of value T(xⱼ) may be proportional to the respective input value xⱼ, in particular proportional to the absolute value and/or sign of the input value xⱼ.

Optionally, depending on the specific embodiment, the duration of each activation signal 21 may be a function of the respective input datum xⱼ and also of one or more control data, as discussed in detail below.

In detail, for performing a MAC operation, the word line activation unit 14 provides a plurality of most significant activation signals S_{1,MSC},..., S_{K,MSC}, one to each word line WLⱼ, during a most significant computation window CW₁; and a plurality of least significant activation signals S_{1,LSC}, ...,S_{K,LSC}, one to each word line WLⱼ, during a least significant computation window CW₂.

Without any loss of generality, the most significant activation signals and the least significant activation signals may also be referred to as the first and second activation signals; and the most significant computation window CW₁ and the least significant computation window CW₂ may also be referred to as the first and second computation windows.

The most significant computation window CW₁ and the least significant computation window CW₂ are distinct from each other, i.e. temporally separated from each other and in particular they are successive to each other, as shown in detail below in reference to Figures 6-8. However, the order of the windows CW₁, CW₂ may be different from that shown.

The IMC device 10 may modulate the durations of the computation windows CW₁, CW₂, as described in detail below, starting from a reference duration T_{R}.

The reference duration T_{R} may be for example of the order of a few hundred nanoseconds, or even lower than about 100 ns, and may be chosen by a user of the IMC device 10 before the start of a new computation, **i.e.** before the start of the computation windows CW₁, CW₂.

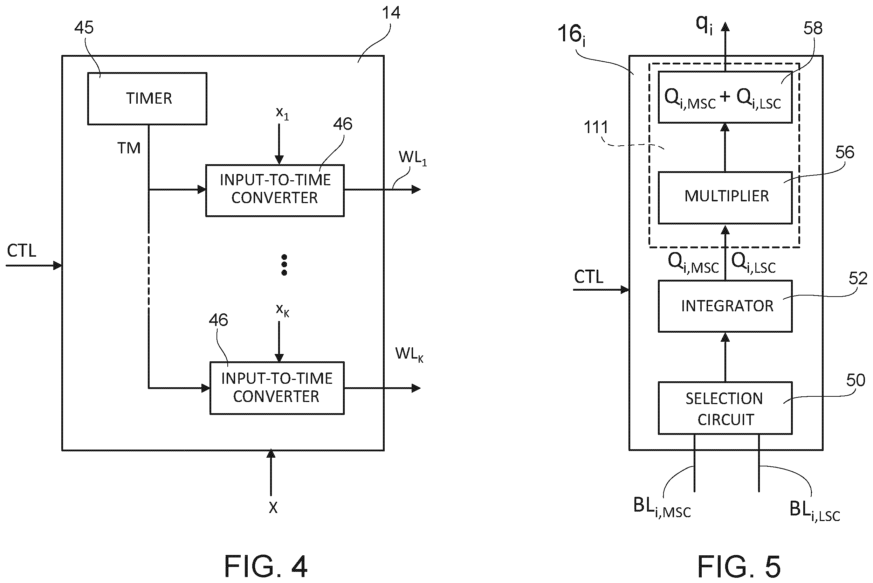

Figure 4 shows a detailed and exemplary embodiment of the word line activation unit 14.

The word line activation unit 14 comprises a timer (or main counter) 45 providing a timer signal TM, and a plurality of input-to-time converters 46, one for each word line WL₁,...,WL_{N}.

The timer signal TM may be configured to adjust the durations of the computation windows CW₁, CW₂.

The input-to-time converters 46 each provide the activation signals S_{j,MSC}, S_{j,LSC} to the respective word line WLⱼ starting from the timer signal TM and the respective input datum xⱼ.

The word line activation unit 14 may also receive an address signal ADR indicating which word lines WLⱼ to activate in order to perform an in-memory calculation, for example in case only some of the word lines are to be used for the computation.

The word line activation unit 14 may also receive one or more control signals CTL, for example from a control unit 31 of the IMC device 10 or of the apparatus wherein the IMC device 10 is integrated.

The control signals CTL may for example indicate the current computation window (CW₁ or CW₂), the start of the computation windows CW₁, CW₂ and/or which of the two computation windows CW₁, CW₂ to perform first.

The read circuit 15 is coupled to the bit lines BL₁,...,BL_{M}, samples the bit line currents I_{BL,1},...,I_{BL,M} that flow through the bit lines BL₁,...,BL_{M} and, in response, provides the output signal Y=y₁,...,y_{L}.

In detail, the read circuit 15 comprises a respective digital detector 16ᵢ and a respective DSP 17ᵢ for each output datum yi, with i=1,...,L.

Each digital detector 16ᵢ is coupled to the bit lines of the groups of memory cells 22_{1,1} to 22_{1,K}.

For example, with reference to the arrangement of Figure 2, the digital detector 16₁ is coupled to the bit lines BL₁ and BL₂ and the digital detector 16_{L} is coupled to the bit lines BL_{M-1} and BL_{M}.

Each digital detector 16ᵢ is an analog-to-digital converter (ADC) that generates a respective charge signal qᵢ indicative of the amount of charge that has flowed in the respective bit lines BL_{i,MSC} and BL_{i,LSC} during the computation windows CW₁, CW₂.

As discussed in detail below, the charge signal qᵢ is indicative of the MAC operation between the input data x₁,...,x_{K} and the computation weights Gᵢ₁,...,G_{iK}.

In practice, the charge signal qᵢ is a digital signal obtained starting from the discretization of the bit line currents that have flowed in the respective bit lines BL_{i,MSC} and BL_{i,LSC} during the computation windows CW₁, CW₂.

For example, each charge signal qᵢ may have a number of bits equal to F that may vary depending on the specific application; for example, the number F of bits may depend on the number of bits of the MSC and LSC cells, on the number of memory cells coupled to the bit line BLᵢ, on the desired calculation accuracy, etc. For example, in case the number of bits of the MSC and LSC cells is N, F may be equal to 2N.

Each DSP 17ᵢ is coupled to the respective digital detector 16i, processes the respective charge signal qᵢ and, in response, provides the respective output datum yᵢ.

For example, the DSP 17ᵢ may provide the respective output datum yᵢ in response to the comparison of the respective charge signal qᵢ with one or more specific reference values, for example defined during the design or calibration step of the IMC device 10. Additionally, or alternatively, the DSP 17ᵢ may perform other processing steps useful for a successive processing of the same output signal yi, for example depending on the specific device to which the output signal yᵢ is provided.

The digital detectors 16 may receive the one or more control signals CTL.

In detail, as shown in the embodiment of Figure 5, each digital detector 16ᵢ comprises a selection circuit 50 that selects one of the respective bit lines BL_{i,MSC} and BL_{i,LSC} depending on the current computation window (CW₁ or CW₂); and an integrator 52 that provides a signal Q_{i,MSC} indicative of the most significant charge (also indicated hereinafter for simplicity by Q_{i,MSC}) measured starting from the current that flows in the bit line BL_{i,MSC} and a signal Q_{i,LSC} indicative of the least significant charge (also indicated for simplicity by Q_{i,LSC}) measured starting from the current that flows in the bit line BL_{i,LSC}.

The signals Qᵢ,_{MSC}, Q_{i,LSC} may be discrete (digital) signals obtained starting from the sampling of the respective currents during the computation window CW₁ and, respectively, CW₂.

For example, the signals Qᵢ,_{MSC}, Q_{i,LSC} may be binary-coded digital signals.

For example, the signals Qᵢ,_{MSC}, Qᵢ,_{LSC} may be digital signals each having 2N bits.

Optionally, for example depending on the specific embodiment, a multiplier 56 may multiply the signals Q_{i,MSC}, Q_{i,LSC}, as described in detail below.

An adder 58 adds the signals Qᵢ,_{MSC}, Q_{i,LSC} and provides the charge signal qᵢ.

The IMC device 10 may further comprise interface circuits 30 (Figure 2) including row decoding and selection circuits, column decoding and selection circuits, and read-write circuits useful for the operation of the IMC device 10 and known per se. For example, the read-write circuits may be used to program the conductance value of the memory cells 20.

Figure 6 shows an exemplary diagram of a computation method of a MAC operation by the IMC device 10, according to one embodiment.

In Figure 6, the IMC device 10 provides the most significant activation signals S_{1,MSC},...,S_{K,MSC} and processes the most significant bit lines BL_{i,MSC} in the most significant computation window CW₁, and provides the least significant activation signals S_{1,LSC},...,S_{K,LSC} and processes the least significant bit lines BL_{l,LSC} in the least significant computation window CW₂.

In the embodiment of Figure 6, the word line activation unit 14 defines the duration TC₂ of the computation window CW₂ in such a way that it is equal to the reference duration T_{R}, i.e., TC₂=T_{R}; and the duration TC₁ of the processing window CW₁ in such a way to be a function of the number of bits N of the memory cells 20 and of the reference duration T_{R}, in particular a function of the product between the number of levels 2^{N} and the reference duration T_{R}.

In the embodiment shown, the duration TC₁ is proportional to the product 2^{N}·T_{R}, in particular TC₁=T_{R}·2^{N}.

With reference to a generic word line WLⱼ, within the computation window CW₁ (which extends for example between the instants t₁ and t₂ of Figure 6), the row activation unit 14 provides the respective most significant activation signal S_{j,MSC} to the respective word line WLⱼ.

The most significant activation signal S_{j,MSC} has an activation duration T_{j,MSC} which is a function of the respective duration of value T(xⱼ) and the number of bits N of the memory cells 20.

In particular, the function that associates the activation duration T_{j,MSC} with the duration of value T(xⱼ) and number of bits N may be the same function that associates the processing duration TC₁ with respect to the reference duration T_{R} and the number of bits N.

In the embodiment shown, T_{j,MSC}=T(xⱼ)·2^{N}. Purely by way of example, if T(xⱼ)=128 ns and N=2, then T_{j,MSC}=128 ns·4=512 ns.

Still with reference to the generic word line WLⱼ, within the computation window CW₂ (which extends for example between the instants t₃ and t₄ of Figure 6), the row activation unit 14 provides the respective least significant activation signal S_{j,LSC} to the respective word line WLⱼ.

The least significant activation signal S_{j,LSC} has a duration equal to the duration of value T(xⱼ).

In practice, in the embodiment of Figure 6, the most significant activation duration T_{j,MSC} is greater than the respective least significant activation duration T_{j,LSC} and the ratio T_{j,MSC}/T_{j,LSC} is a function of the number N of bits of the least significant cell LSC, in particular equal to 2^{N}.

During the computation window CW₁, each digital detector 16ᵢ processes (interval 60 of Figure 6) the respective most significant bit line BL_{i,MSC}.

For example, with reference to the configuration shown, the digital detector 16₁ processes the bit line BL₁.

In detail, during the first computation window CW₁, each most significant cell MSC is traversed by a current I_{MSC} having a magnitude **(i.e.,** absolute value) that depends on the resistance level R_{MSC} programmed in the most significant cell MSC and a duration that depends on, in particular is equal to, the activation duration T_{j,MSC} of the respective activation signal S_{j,MSC}.

The most significant cell MSC of the group of memory cells 22_{i,j} therefore contributes during the processing window CW₁ to a charge shift Q_{i,j,MSC} which is a function of the product between the activation duration T_{j,MSC} and the respective conductance level g_{i,MSC}.

Thus, overall, each most significant bit line BL_{i,MSC} (e.g. the bit line BL₁ in the configuration of Figure 2) contributes to an overall charge shift Q_{i,MSC} that depends on the sum of all charge contributions Q_{i,j,MSC}, i.e. ${\sum }_{j = 1}^{K} {Q}_{i , j , MSC}$*.*

With reference to Figure 5, during the computation window CW₁, the selection circuit 50 of the digital detector 16ᵢ selects the most significant bit line BL_{i,MSC}, in such a way that the integrator 52 integrates the respective current I_{BLi,MSC} and then generates in response the most significant charge signal Q_{i,MSC}.

During the computation window CW₂, each digital detector 16ᵢ processes (interval 61 of Figure 6) the respective least significant bit line BL_{i,LSC}.

For example, with reference to the configuration shown, the digital detector 16₁ processes the bit line BL₂.

In detail, during the computation window CW₂, each least significant cell LSC is traversed by a current I_{LSC} having a magnitude (i.e., absolute value) that depends on the resistance level R_{LSC} programmed in the least significant cell LSC and a duration that depends on, in particular is equal to, the activation duration T_{j,LSC} of the respective activation signal S_{j,LSC}.

The least significant cell LSC of the group of memory cells 22_{i,j} therefore contributes during the computation window CW₂ to a charge shift Q_{i,j,LSC} which is a function of the product between the activation duration T_{j,LSC} and the respective conductance level g_{i,LSC}.

Thus, overall, each least significant bit line BL_{i,LSC} (e.g., the bit line BL₂ in the configuration of Figure 2) contributes to an overall charge shift Q_{i,LSC} that depends on the sum of all charge contributions Q_{i,j,LSC}, i.e. ${\sum }_{j = 1}^{K} {Q}_{i , j , LSC}$*.*

With reference to Figure 5, during the computation window CW₂, the selection circuit 50 of the digital detector 16ᵢ selects the least significant bit line BL_{i,LSC}, in such a way that the integrator 52 integrates the respective current I_{BLi,LSC} and then generates in response the least significant charge signal Q_{i,LSC}.

In this embodiment, the most significant charge Q_{i,MSC} and the least significant charge Q_{i,LSC} are not subject to multiplication by the multiplier 56.

The adder 58 adds the most significant charge signal Q_{i,MSC} and the least significant charge signal Q_{i,LSC}, thus generating in response the charge signal qᵢ.

The fact that both durations T_{j,MSC} and T_{j,LSC} are both a function of the respective input value xⱼ but different from each other as a function of the number of bits N allows to assign a different significance to the charge contributions Q_{i,MSC} and Q_{i,LSC}.

In particular, the fact that the ratio between the durations T_{j,MSC} and T_{j,LSC} is greater than 1 and a function of 2_{N} allows to assign to the charge contribution Q_{i,MSC} of the most significant cells MSC a greater weight than the charge contribution Q_{i,LSC} of the least significant cells LSC.

Since the charge contributions Q_{i,MSC}, Q_{i,LSC}, also depend on the resistance levels R_{i,MSC} and, respectively, R_{i,LSC} of each group of memory cells 22_{i,j}, the MSC, LSC cells may be used to map different groups of bits of the computation weight Gᵢⱼ.

In other words, this allows to obtain a multiplication by 2^{N} of the contribution associated with the most significant bits and add it to the contribution associated with the least significant part.

In practice, this allows to use the group of memory cells 22_{i,j}, formed by two cells (MSC, LSC) each having a number N of bits, to map a computation weight Gᵢⱼ having a number 2N of bits. In general, if the two cells MSC and LSC have respectively a number of bits N_{MSC} and N_{LSC}, a computation weight Gᵢⱼ having a number N_{MSC}+N_{LSC} of bits may be mapped.

Therefore, the IMC device 10 has a high efficiency in mapping computation weights G having a high number of bits in the memory array 12.

The IMC device 10 may therefore have a high weight-mapping density in the array 12.

Furthermore, in the embodiment of Figure 6, the fact that the duration TC₂ of the computation window CW₂ is equal to the reference duration T_{R} may allow the word line activation circuit 14 to provide the least significant activation signal S_{j,MSC} with high accuracy.

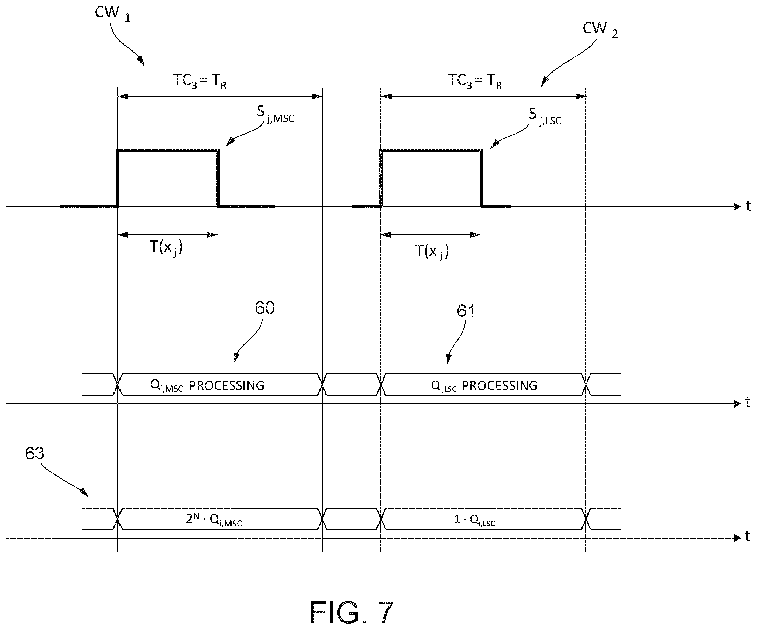

Figure 7 shows an exemplary diagram of a computation method of a MAC operation by the IMC device 10, according to a different embodiment.

Also in Figure 7, the IMC device 10 provides the most significant activation signals S_{1,MSC}, ...,S_{K,MSC} and processes the most significant bit lines BL_{i,MSC} in the computation window CW₁, and provides the least significant activation signals S_{1,LSC}, ...,S_{K,LSC} and processes the least significant bit lines BL_{i,LSC} in the computation window CW₂.

In the embodiment of Figure 7, the computation windows CW₁, CW₂ have a same processing duration TC₃.

In particular, the processing duration TC₃ may be equal to the reference duration T_{R}, i.e. TC₃=T_{R}.

Furthermore, in this embodiment, with reference to a generic word line WLⱼ, the most significant activation signal S_{j,MSC} and the least significant activation signal S_{j,LSC} have a same duration which is a function only of the respective duration of value T(xⱼ), in particular T_{j,MSC}=T_{j,LSC}=T(xⱼ). Purely by way of example, it may be T_{j,MSC}=T_{j,LSC}=T(xⱼ)=128 ns.

During the computation window CW₁, each digital detector 16ᵢ processes (step 60) the respective most significant bit line BL_{i,MSC} and, during the computation window CW₂, each digital detector 16ᵢ processes (step 61) the respective least significant bit line BL_{i,MSC}, similarly to what has been discussed for the embodiment of Figure **6****.**

In this embodiment, the processing also comprises a step 63 of multiplying one or more of the signals Q_{i,MSC}, Q_{i,LSC}.

In particular, the most significant charge signal Q_{i,MSC} indicative of the charge measured during the computation window CW₁ is multiplied, by the multiplier 56, by a multiplication factor P_{MSC} which is a function of the number of bits N of the least significant cell LSC of the group of memory cells 22_{i,j}.

In detail, the multiplication factor P_{MSC} may be proportional to the total number of levels 2^{N} at which the least significant cell LSC may be programmed. In particular, in this embodiment, P_{MSC} = 2^{N}.

The least significant charge signal Q_{i,LSC} indicative of the charge measured during the computation window CW₂ may be multiplied, by the multiplier 56, by a multiplication factor P_{LSC} that may be a function of the number of bits N of the least significant cell LSC of the group of memory cells 22_{i,j}. In particular, in this embodiment, P_{LSC} = 1; i.e., the least significant charge signal Q_{i,LSC} does not undergo any multiplication.

The charge signal qᵢ provided by the adder 58 is therefore given, in this embodiment, by 2^{N}·Q_{i,MSC}+Q_{i,LSC}.

The fact that the most significant charge signal Q_{i,MSC} is multiplied by a different factor with respect to the least significant charge signal Q_{i,LSC} allows to assign a different significance to the charge contributions Q_{i,MSC} and Q_{i,LSC}.

In particular, the fact that the ratio P_{MSC}/P_{LSC} is a function of 2^{N} allows to assign to the charge contribution Q_{i,MSC} of the most significant cells MSC a greater significance with respect to the charge contribution Q_{i,LSC} of the least significant cells LSC.

Since the charge contributions Q_{i,MSC}, Q_{i,LSC} also depend on the resistance levels R_{i,MSC} and, respectively, R_{i,LSC} of each group of memory cells 22_{i,j}, the MSC, LSC cells may be used to map different groups of bits of the computation weight Gᵢⱼ.

In practice, this allows to use the group of memory cells 22_{i,j}, formed by two cells (MSC, LSC) each having a number N of bits, to map a computation weight Gᵢⱼ having a number 2N of bits.

The method described with reference to Figure 7 allows to maintain the activation times of the memory cells low and therefore to reduce the overall computation time (i.e. the overall duration given by the sum of the computation windows CW₁ and CW₂) with respect to the method described with reference to Figure 6.

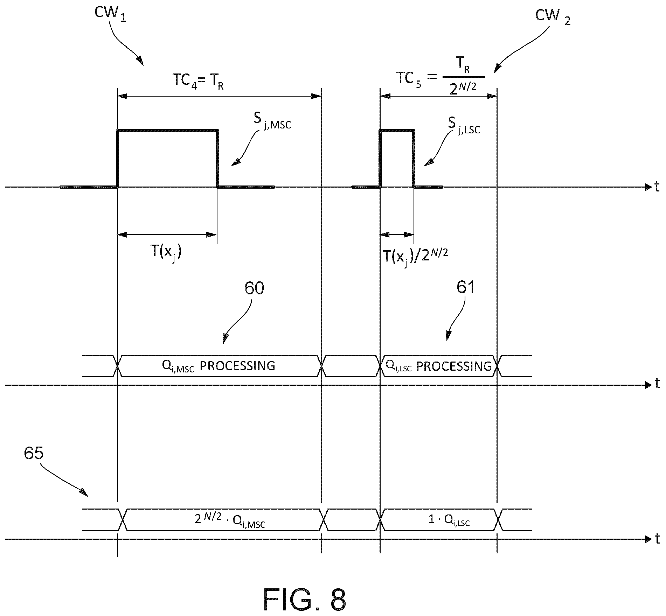

Figure 8 shows an exemplary diagram of a method for performing a MAC operation by the IMC device 10, according to a further embodiment.

In this embodiment, the computation window CW₁, wherein the most significant cells MSC are activated, has a duration TC₄ equal to the reference duration T_{R}, and the computation window CW₂, wherein the least significant cells LSC are activated, has a duration TC₅ lower than the reference duration T_{R}.

In detail, the duration TC₅ of the second computation window CW₂ is equal to the reference duration T_{R} reduced by a reduction factor which is a function of the number of bits N of the least significant cells LSC, in particular a function of the respective number of resistance levels 2^{N}.

In the embodiment shown, the reduction factor is equal to 2^{N/2}.

Consequently, the duration T_{j,MSC} of the most significant activation signal S_{j,MSC} is equal to the duration of value T(xⱼ) and the duration T_{j,LSC} of the least significant activation signal S_{j,LSC} is equal to the duration of value T(xⱼ) decreased by the reduction factor, in particular 2^{N/2}.

Purely by way of example, if T_{j,MSC}=T(xⱼ)=128 ns and N=4, then T_{j,LSC}=128 ns/4=32 ns.

Similarly to what has been described for the embodiment of Figure 7, also in this embodiment the processing also comprises a step, here indicated by 65, of multiplying one or more of the signals Q_{i,MSC}, Q_{i,LSC}.

In detail, the most significant charge signal Q_{i,MSC} is multiplied by a multiplication factor P_{MSC} which is a function of the number of bits N of the respective least significant cell LSC.

In particular, the multiplication factor P_{MSC} may be equal to the reduction factor 2^{N/2}, i.e. 2^{N/2}·Q_{i,MSC}. Purely by way of example, if N=4, then P_{MSC}=4.

Also in this embodiment, P_{LSC} = 1.

Therefore it is clear that, similarly to what has been described in reference to the embodiments of Figures 6 and 7, in the embodiment of Figure 8 the different significance between the most significant charge signal Q_{i,MSC} and the least significant charge signal Q_{i,LSC} is obtained both through a different duration between the signals S_{j,MSC} and S_{j,LSC}, and through a different multiplication factor P_{MSC}, P_{LSC} of the signals Q_{i,MSC}, Q_{i,LSC}.

Therefore, also according to what has been described in reference to Figure 8, the group of memory cells 22_{i,j}, formed by two cells (MSC, LSC) each having a number N of bits may be used, to map a computation weight Gᵢⱼ having a number 2N of bits; thus obtaining a high efficiency.

Furthermore, according to the embodiment of Figure 8, a high versatility in mapping the computation weights Gᵢⱼ may be obtained.

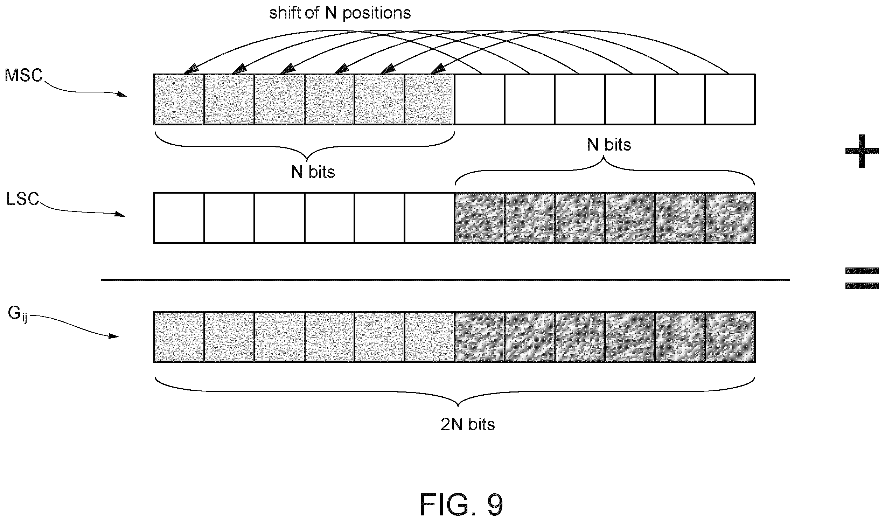

In practice, as shown in the schematic representation of Figure 9, the methods described in reference to Figures 6-8 allow to map in each group of memory cells 22_{i,j}, using two memory cells (MSC and LSC) each having N bits, a respective computation weight Gᵢⱼ having a number of bits equal to 2N, i.e. equal to the sum of the number of bits of the most significant cell MSC and the least significant cell LSC.

In other words, for each group of memory cells 22_{i,j}, the described methods allow, during the computation, to assign to the resistance value or level stored in the respective most significant cell MSC a greater significance with respect to the resistance value or level stored in the respective least significant cell LSC.

According to one embodiment, each digital detector 16ᵢ may be configured to generate the signals Q_{i,MSC}, Q_{i,LSC} by converting the current that flows in the bit lines BL_{i,MSC} and BL_{i,LSC} during the respective computation windows CW₁, CW₂ into a number of charge packets and counting the number of charge packets.

In detail, the digital detector 16ᵢ may perform a number of successive sampling iterations of the current that flows in the respective bit line. In each sampling iteration, the digital detector 16ᵢ may: generate an integral signal (e.g., a voltage) indicative of the time integral of the bit line current; compare the integral signal with a threshold and; in response to the integral signal reaching the threshold, reset the first integral signal and update the charge signal Q_{i,MSC}, Q_{i,LSC}.

In particular, each digital detector 16ᵢ may be the same as the digital detectors 22, 322, or 422 of European patent application number 23216192.7.

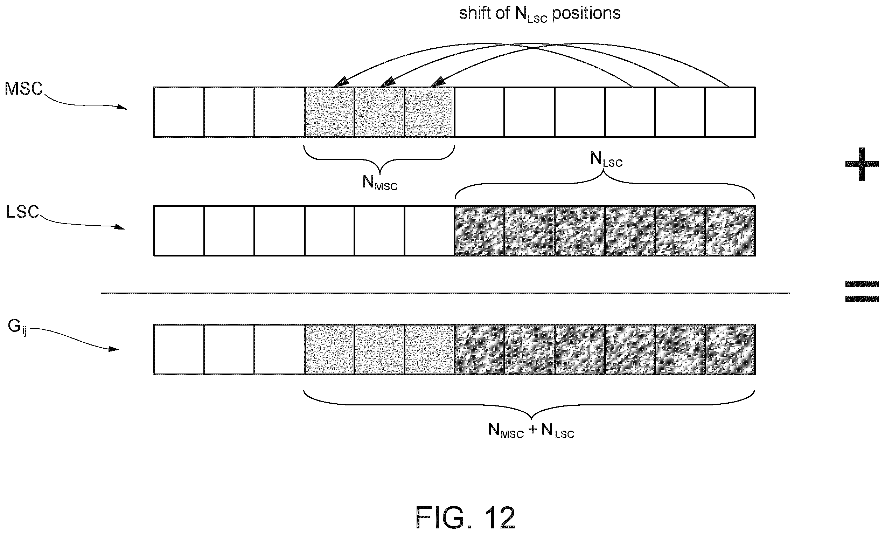

For example, the integrator 52 may be the same as one of the integration stages described in European patent application number 23216192.7; for example, it may be the same as the integration stage 33 described with reference to Figures 2-4, the integration stage 330 of Figure 12, or the integration stage 430 of Figure 14 of European patent application number 23216192.7.

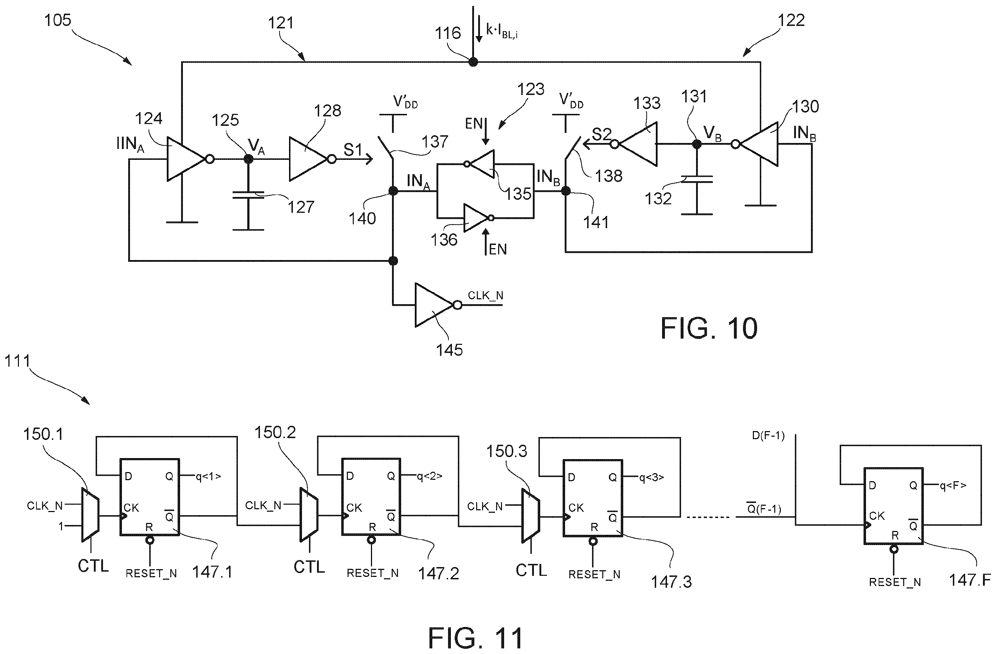

With reference to Figure 10, one embodiment of the integrator, here indicated by 105, of any of the digital detectors 16ᵢ is briefly described hereinbelow, in a case wherein the integrator is the same as the integration stage 33 described in European patent application number 23216192.7. The integrator 105 may comprise a first integration circuit 121, a second integration circuit 122 and a switching circuit 123 coupled between the first and the second integration circuits 121, 122.

The first and the second integration circuits 121, 122 are coupled to an input node 116 from which it receives a current indicative of the bit line current, for example k·I_{BL,l}.

The first integration circuit 121 comprises a first inverter 124 having an output 125, a capacitor 127 of capacitance C_{A} coupled to the output 125 of the first inverter 124, and a second inverter 128 whose input is coupled to the output 125 of the first inverter 124.

The first inverter 124 has a supply node coupled to the input node 116 of the integrator 105 and receives at input a first control signal IN_{A}.

In practice, the first inverter 124 is biased by the current k·I_{BL,l}.

The capacitor 127 has a first terminal coupled to the output node 125 of the first inverter 124 and a second terminal coupled to a reference node, here to ground.

The output node 125 of the first inverter 124 is at a first integration voltage V_{A} that drops across the capacitor 127.

The second inverter 128 has a first sampling threshold, hereinafter referred to as the first threshold Vₜₕ₁, receives at input the first integration voltage V_{A} and provides at output a first switch signal S1 as a function of the first threshold Vₜₕ₁ and the first integration voltage V_{A}.

In detail, the first switch signal S1 is a logic signal having a high logic value when the first integration voltage V_{A} is lower than the first threshold Vₜₕ₁, and a low logic value when the first integration voltage V_{A} is higher than the first threshold Vₜₕ₁.

The second integration circuit 122 comprises a first inverter 130 having an output 131, a capacitor 132 of capacitance C_{B} coupled to the output 131 of the first inverter 130, and a second inverter 133 whose input is coupled to the output 131 of the first inverter 130.

The first inverter 130 has a supply node coupled to the input node 116 and receives at input a second control signal IN_{B}.

In practice, the first inverter 130 is biased by the current k·I_{BL,l}.

The capacitor 132 has a first terminal coupled to the output node 131 of the first inverter 130 and a second terminal coupled to a reference node, here to ground.

The output node 131 of the first inverter 130 is at a second integration voltage V_{B} that drops across the capacitor 131.

The second inverter 133 has a second sampling threshold Vₜₕ₂, hereinafter referred to as the second threshold Vₜₕ₂, receives at input the second integration voltage V_{B} and provides at output a second switch signal S2 as a function of the second threshold Vₜₕ₂ and the second integration voltage V_{B}.

In detail, the second switch signal S2 is a logic signal having a high logic value when the second integration voltage V_{B} is lower than the second threshold Vₜₕ₂, and a low logic value when the second integration voltage V_{B} is higher than the second threshold Vₜₕ₂.

The switching circuit 123 is a latch formed by two inverters 135, 136 arranged in a ring configuration, a first switch 137 controlled by the first switch signal S1 and a second switch 138 controlled by the second switch signal S2.

The switching circuit 123 has a first node 140 coupled to the input of the inverter 136 and the output of the inverter 135, and a second node 141 coupled to the output of the inverter 136 and the input of the inverter 135.

The first node 140 provides the first control signal IN_{A}. The second node 141 provides the second control signal IN_{B}.

The first switch 137 is coupled between the first node 140 and a node at a voltage V'_{DD}, the second switch 138 is coupled between the second node 141 and the node at the voltage V'_{DD}.

In this embodiment, the switching circuit 123 also receives an enable signal EN, which controls the activation of the switching circuit 123. For example, the enable signal EN may be used to maintain the switching circuit 123 off when not in use, thereby allowing for energy consumption to be optimized. Furthermore, the enable signal EN may be used to set the switching circuit 123 to a defined state, such as when the IMC device 10 is powered up.

In practice, the control signal IN_{A} at node 140 indicates the integration voltage V_{A} reaching the threshold V_{th,1} and, therefore, each switching of the control signal IN_{A} is indicative of a new charge packet to be counted.

The integrator 105 may also comprise a counting inverter 145 whose input is coupled to the node 140. In practice, the counting inverter 145 provides a packet counting signal CLK_N, having a value opposite to the control signal IN_{A}. Therefore, the packet counting signal CLK_N is also indicative of the new charge packet to be counted.

When the digital detector 16ᵢ comprises the integrator 105, the digital detector 16ᵢ may also comprise a counter configured to update the number of charge packets counted (and therefore the value of the charge signal Q_{i,MSC} or Q_{i,LSC}) as a function of the packet counting signal CLK_N.

According to one embodiment, each digital detector 16ᵢ may comprise a counting stage 111 configured to count the charge packets detected by the integrator 105 and comprising the multiplier 56 and the adder 58, as indicated by a dashed rectangle in Figure 5.

In detail, Figure 11 shows a detailed embodiment of the counting stage 111.

The counting stage 111 is implemented through a ripple counter-type circuit, in particular with D-type flip-flops.

The counting stage 111 is coupled to the integrator 52, 105 and receives from the integrator 52, 105 a signal indicative of the charge packets measured by the integrator 52.

For example, with reference to the embodiment of the integrator 105 of Figure 10, the counting stage 111 may receive the packet counting signal CLK_N.

Hereinafter, for simplicity and without any loss of generality, the signal received by the counting stage 111 by the integrator 52 will be indicated by CLK_N.

The counting stage 111 may comprise a number F of flip-flops 147.1,...,147.F and a number G≤F of multiplication selectors 150,...,150.G, where F is the number of bits of the charge signal qᵢ.

In practice, each flip-flop 147.1,...,147.F provides a respective bit q<1>,...,q<F> of the charge signal qᵢ.

In the embodiment shown, the multiplication selectors 150.1,...,150.G are each arranged upstream of a respective flip-flop 147.1,...,147.G, i.e., a multiplication selector for each of the first G flip-flops. However, the counting stage 111 may comprise a different number of multiplication selectors, depending on the multiplication factors that are intended to be used.

The flip-flops 147.1,...,147.F each have a clock input (CK-input), a data input (D-input), a reset input (R-input), a Q-output (or first output) and a *Q̅*-output (or second output) .

The first multiplication selector 150.1 has a first selectable input from which it receives the packet counting signal CLK_N and a second selectable input from which it receives a reference bit, for example '1' in the example shown.

The multiplication selectors 150.2,...,150.G each have a first selectable input from which they receive the packet counting signal CLK_N and a second selectable input coupled to the data input D of a respective downstream flip-flop 147.1,...,147.G-1.

The multiplication selectors 150.1,...,150.G are each controlled by one or more control signals, also here identified without any loss of generality by CTL, indicative of the multiplication factor (e.g., P_{MSC} and/or P_{LSC} described with reference to Figures 7 and 8) that is desired to be applied during the count of the charge packets.

The R-inputs of the flip-flops 147.1,...,147.F receive a reset signal RESET_N, for example generated by the control unit 31 and configured to reset the flip-flops 147.1,...,147.F when necessary (for example when the IMC device 10 is switched on and, more generally, whenever it is needed to have known starting values stored in the flip-flops 147.1,...,147.F, for example at the beginning of a new computation).

The CK-inputs of the flip-flops 147.1,...,147.G are connected, in particular directly coupled, each to the output of the respective multiplication selector 150.1,...,150.G upstream.

The *Q̅*-output of each flip-flop 147.f, with f=1,...,G-1, is coupled to the input D of the same flip-flop 147.f and to one of the inputs to be selected of the multiplication selector 150.f downstream.

For example, the *Q̅*-output of the flip-flop 147.1 is coupled to one of the inputs to be selected of the multiplication selector 150.2.

The Q-output of the flip-flops 147.1,...,147.F is each the respective bit q<1>,...,q<F> of the charge signal qᵢ.

In practice, in response to the detection of each charge packet by the integrator 52, 105 (and therefore to a switching of the packet counting signal CLK_N), the counting stage 111 increases one of the bits of the charge signal qi, according to the weight that is intended to be assigned to the count of the new charge packet.

The control signal CTL determines which of the bits of the charge signal qᵢ to increase, as a function of the desired multiplication factor.

For example, in case it is not desired to perform a multiplication (or, in other words, the multiplication factor is equal to 1), the control signal CTL controls the first multiplication selector 150.1 in such a way that it provides at output the signal CLK_N only to the flip-flop **147.1.**

In other words, if it is not desired to perform a multiplication, the packet counting signal CLK_N is used to increase the least significant bit q<1> of the charge signal qᵢ.

If it is desired to perform a multiplication by a factor of 2, then the control signal CTL controls the multiplication selectors **150.1,...,150.G** in such a way that the packet counting signal CLK_N is provided only to the second flip-flop 147.2.

If it is desired to perform a multiplication by a factor of 4, then the control signal CTL controls the multiplication selectors **150.1,...,150.G** in such a way that the packet counting signal CLK_N is provided only to the third flip-flop 147.3.

In general, if it is desired to perform a multiplication by a factor (P_{MSC} or P_{LSC}) equal to 2^{p}, with p=0,...,G then the control signal CTL controls the multiplication selectors **150.1,...,150.G** in such a way that the packet counting signal CLK_N is provided at input to the p+1-th flip-flop 147.p.

The counting stage 111 of Figure 11 may be used both during the first computation window CW₁ and during the second computation window CW₂, without resetting the flip-flops 147.1, ...,147.F between the computation window CW₁ and the computation window CW₂.

Therefore, the counting stage 111 may be used to count the total number of charge packets measured by the integrator 105 during the entire computation interval CW₁+CW₂.

In practice, the signal qᵢ provided at output may be indicative of the sum between the charges Q_{i,MSC} and Q_{i,LSC}. In other words, the counting stage 111 may be used to implement also the adder 58 of Figure 5.

The embodiments described in reference to Figures 10 and 11 may contribute, both individually and in combination, to increasing the computation efficiency of the IMC device 10.

In fact, the integrator 105 allows to perform the integration of the currents of the bit lines BL_{i,MSC} and BL_{i,LSC} during the respective computation windows CW₁ and, respectively, CW₂, thus maintaining the overall computation times of the MAC operation low.

The counting stage 111 allows to provide the signal qᵢ efficiently, while maintaining the computation times and the energy consumption of the IMC device 10 low.

Finally, it is clear that modifications and variations may be made to what has been described and illustrated herein without thereby departing from the scope of the present invention, as defined in the attached claims.

The IMC device 10 may comprise one or more memories and one or more processing units operationally coupled to each other, for example implemented in the control unit 31, configured to store and execute one or more computer programs (software) configured to control the IMC device 10, according to what has been discussed in the present patent application.

For example, with reference to a generic group of memory cells 22_{i,j}, the most significant cell MSC may have a number of bits N_{MSC} different from the number of bits N_{LSC} of the least significant cell LSC. In this case, as shown schematically in the diagram of Figure 12, each of the methods described with reference to Figures 6-8 may be used to map a computation weight Gᵢⱼ having a number of bits equal to N_{MSC}+N_{LSC}. In this case, the ratio T_{j,MSC}/T_{j,LSC} and/or the ratio P_{MSC}/P_{LSC} may be a function of the number of bits N_{LSC}, in particular equal to 2*^{N_{LSC}}*.

In particular, it may be T_{j,MSC}/T_{j,LSC} · P_{MSC}/P_{LSC} = 2^{NLSC}.

More generally, the ratio T_{j,MSC}/T_{j,LSC} and/or the ratio P_{MSC}/P_{LSC} may be obtained through one or more multiplication and/or division (i.e., multiplication with a multiplication factor lower than 1) operations, depending on the specific implementation.

In case the memory cells of a respective group of cells 22_{i,j} have a different number of bits from each other, then the memory cell having the highest number of bits may be chosen as the most significant cell MSC of the group of cells 22_{i,j}. Instead, in case the memory cells of the respective group of cells 22_{i,j} have the same number of bits with each other, then the most significant cell MSC may be chosen randomly among the memory cells of the group of cells 22_{i,j}.

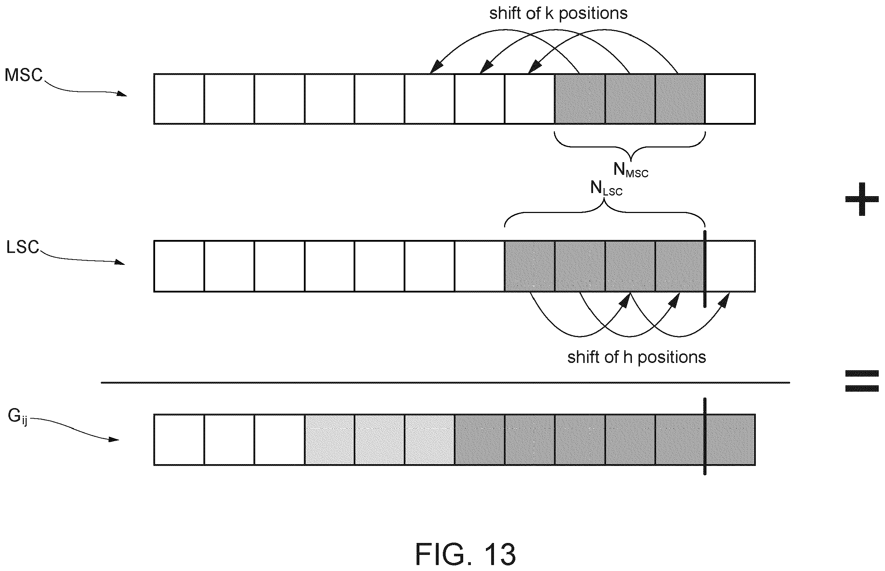

For example, as shown schematically in the diagram of Figure 13, the significance of the MSC cell may be adjusted through a multiplication by a multiplication factor which is a function of a value k and the significance of the LSC cell may be adjusted through a division by a division factor which is a function of a value h, where k+h≤max(N_{MSC},N_{LSC}).

Optionally, one or more of the values mapped by the MSC, LSC cells may also undergo a truncation operation, depending on the specific application.

For example, the ratio T_{j,MSC}/T_{j,LSC} and/or the ratio P_{MSC}/P_{LSC} may be a function of one or more of the numbers of bits N_{MSC}, N_{LSC}, depending on the specific mapping of the computation weights intended to be implemented.

For example, the most significant computation window CW₁ may be performed after the least significant computation window CW₂.

For example, for each group of cells 22_{i,j}, the most significant cell MSC and the least significant cell LSC may receive the most significant activation signal and the least significant activation signal having the durations discussed above, but be coupled to word lines different from each other.

For example, for each group of memory cells 22_{i,j}, the most significant memory cell MSC and the least significant memory cell LSC may be coupled to bit lines that are different but not adjacent to each other. Purely by way of example, with reference to the group of memory cells 22_{1,1}, the MSC cell may be coupled to the bit line BL₁ and the LSC cell may be coupled to the bit line BL₄.

For example, the groups of memory cells 22_{i,j} may each comprise a number of memory cells greater than two, each configured to map a respective group of bits of the respective computation weight G_{i,j} and each configured to be activated in a respective computation window, similarly to what has been discussed in reference to Figures 6-8.

For example, the memory cells 20 may be resistive memory cells not based on PCM materials, but on different technologies; for example, they may be magnetoresistive (MRAM), resistive (RRAM) or static (SRAM) memory cells.

For example, the IMC device 10 may comprise a number of digital detectors and/or DSPs lower than the number L of output data y₁,...,y_{L}. In this case, the generation of the charge signals q₁,...,q_{L} starting from the respective bit currents may be controlled by specific multiplexing circuits known per se.

For example, the DSPs 17₁,...,17_{L} may be optional and the IMC device 10 may provide at output directly the charge signals q₁,...,q_{L}.

One or more of the digital detectors 16₁,...,16_{L} may comprise circuits, units or modules different from what has been shown and described, depending on the specific implementation. For example, one or more of the digital detectors 16₁,...,16_{L} may comprise, upstream of the integrator 52 (or incorporated in the integrator 52) current conditioning circuits such as for example current mirrors, filters, amplifiers, reducers, etc.

Finally, the different embodiments described above may be combined to provide further solutions.

According to one aspect, the present invention also relates to a computer program comprising instructions. Such instructions may be executed by the in-memory computation device 10 comprising the memory array 12 including a group of memory cells 22_{i,j} comprising a first memory cell MSC coupled to a first word line WLⱼ and a first bit line BL_{i,MSC}, where the first memory cell has a first number of bits N_{MSC} and is programmed to have a first electrical quantity R_{i,MSC} (or g_{i,MSC}) as a function of a first computation weight Gᵢⱼ, and a second memory cell LSC coupled to a second word line WLⱼ and to a second bit line BL_{i,LSC}, where the second memory cell has a second number of bits N_{LSC} and is programmed to have a second electrical quantity R_{i,LSC} (or g_{i,LSC}) as a function of the first computation weight. Such instructions comprise, by an activation circuit 14 and towards the in-memory computation device 10:
providing a first activation signal S_{j,MSC} to the first word line W_{Lj} during a first computation window CW₁, the first activation signal having a first duration T_{j,MSC} which is a function of a first input value xⱼ; and
providing a second activation signal (S_{j,LSC}) to the second word line (WLⱼ) during a second computation window (CW₂) distinct from the first computation window, the second activation signal having a second duration (T_{j,LSC}) which is a function of the first input value,
wherein the first memory cell (MSC) is configured to be traversed, when activated during the first computation window (CW₁), by a first cell current (I_{MSC}) which is a function of the first electrical quantity (R_{MSC}) and the first activation duration (T_{j,MSC}), wherein the second memory cell (LSC) is configured to be traversed, when activated during the second computation window (CW₂), by a second cell current (I_{LSC}) which is a function of the second electrical quantity (R_{LSC}) and the second activation duration (T_{j,LSC}) ,
wherein the first bit line (BL_{i,MSC}) is configured to be traversed, during the first computation window (CW₁), by a first bit line current (I_{BLi,MSC}) which is a function of the first cell current (I_{MSC}) and wherein the second bit line (BL_{i,LSC}) is configured to be traversed, during the second computation window (CW₂), by a second bit line current (I_{BLi,LSC}) which is a function of the second cell current (I_{LSC}),
said instructions being further configured to cause the control device to, by a read circuit (15):
   generate a first integration signal (Q_{i,MSC}, IN_{A}) indicative of a time integral of the first bit line current during the first computation window;
   generate a second integration signal (Q_{i,LSC}, IN_{A}) indicative of a time integral of the second bit line current during the second computation window; and
   provide a digital signal (qi) indicative of a sum of the first and the second integration signals,
   wherein the first activation duration (T_{j,MSC}) is different from the second activation duration (T_{j,LSC}) and at least one of the first activation duration (T_{j,MSC}) and the second activation duration (T_{j,LSC}) is also a function of at least one of the first number of bits (N_{MSC}) and the second number of bits (N_{LSC}); and/or
   wherein providing the digital signal comprises multiplying at least one of the first integration signal and the second integration signal by at least one multiplication factor (P_{MSC}, P_{LSC}) which is a function of at least one of the first and the second number of bits.

## Claims

1. An in-memory computation, IMC, device (10) comprising:
a memory array (12) including at least one group of memory cells (22_{i,j}) comprising a first memory cell (MSC) couplable to a first word line (WLⱼ) and a first bit line (BL_{i,MSC}), the first memory cell having a first number of bits (N_{MSC}) and being programmable to have a first electrical quantity (R_{i,MSC}, g_{i,MSC}) as a function of a first computation weight (Gᵢⱼ), and a second memory cell (LSC) couplable to a second word line (WLⱼ) and a second bit line (BL_{i,LSC}), the second memory cell having a second number of bits (N_{LSC}) and being programmable to have a second electrical quantity (R_{i,LSC}, g_{i,LSC}) as a function of the first computation weight;
an activation circuit (14) configured to provide a first activation signal (S_{j,MSC}) to the first word line (WLⱼ) during a first computation window (CW₁) and a second activation signal (S_{j,LSC}) to the second word line (WLⱼ) during a second computation window (CW₂) distinct from the first computation window, the first activation signal having a first duration (T_{j,MSC}) which is a function of a first input value (xⱼ), the second activation signal having a second duration (T_{j,LSC}) which is a function of the first input value,
wherein the first memory cell (MSC) is configured to be traversed, during the first computation window (CW₁), by a first cell current (I_{MSC}) which is a function of the first electrical quantity (R_{MSC}) and the first activation duration (T_{j,MSC}), wherein the second memory cell (LSC) is configured to be traversed, during the second computation window, by a second cell current (I_{LSC}) which is a function of the second electrical quantity (R_{LSC}) and the second activation duration (T_{j,LSC}),
wherein the first bit line (BL_{i,MSC}) is configured to be traversed, during the first computation window (CW₁), by a first bit line current (I_{BLi,MSC}) which is a function of the first cell current (I_{MSC}) and wherein the second bit line (BL_{i,LSC}) is configured to be traversed, during the second computation window (CW₂), by a second bit line current (I_{BLi,LSC}) which is a function of the second cell current (I_{LSC}),
the IMC device further comprising a read circuit (15) couplable to the first and the second bit lines and configured to generate a first integration signal (Q_{i,MSC}, IN_{A}) indicative of a time integral of the first bit line current during the first computation window, generate a second integration signal (Q_{i,LSC}, IN_{A}) indicative of a time integral of the second bit line current during the second computation window, and provide a digital signal (qᵢ) indicative of a sum of the first and the second integration signals,
wherein the first activation duration (T_{j,MSC}) is different from the second activation duration (T_{j,LSC}) and at least one of the first activation duration (T_{j,MSC}) and the second activation duration (T_{j,LSC}) is also a function of at least one of the first number of bits (N_{MSC}) and the second number of bits (N_{LSC}), and/or the read circuit (15) is further configured to multiply at least one of the first integration signal and the second integration signal of at least one multiplication factor (P_{MSC}, P_{LSC}) which is a function of at least one of the first number of bits and the second number of bits.

2. The IMC device according to the preceding claim, wherein the first activation duration (T_{j,MSC}) is greater than the second activation duration (T_{j,LSC}) and a ratio (T_{j,MSC}/T_{j,LSC}) between the first activation duration and the second activation duration is a function of the second number of bits (N_{LSC}).

3. The IMC device according to claim 1 or 2, wherein at least one of the first activation duration and the second activation duration, in particular the ratio between the first activation duration and the second activation duration, is a function of 2^{N}, wherein N is the second number of bits (N_{LSC}).

4. The IMC device according to any one of the preceding claims, wherein the read circuit (15) is configured to multiply the first integration signal by a first multiplication factor (P_{MSC}) and/or the second integration signal (Q_{i,LSC}) by a second multiplication factor (P_{LSC}), wherein a ratio between the first and the second multiplication factors (P_{MSC}/P_{LSC}) is a function of the second number of bits (N_{LSC}) and is greater than 1.

5. The IMC device according to any one of the preceding claims, wherein the at least one multiplication factor (P_{MSC}, P_{LSC}), in particular the ratio between the first and the second multiplication factors, is a function of 2^{N}, wherein N is the second number of bits (N_{LSC}).

6. The IMC device according to any one of the preceding claims, wherein the first activation duration (T_{j,MSC}) is different from the second activation duration (T_{j,LSC}) and the ratio between the first and the second activation durations is a function of the second number of bits (N_{LSC}), and wherein the read circuit is configured to multiply the first integration signal (Q_{i,MSC}) by a first multiplication factor (P_{MSC}) and the second integration signal (Q_{i,LSC}) by a second multiplication factor (P_{LSC}) different from the first multiplication factor and the ratio between the first multiplication factor and the second multiplication factor is a function of the second number of bits.

7. The IMC device according to the preceding claim, wherein the ratio between the first and the second activation duration and the ratio between the first and the second multiplication factor are each a function of 2^{N/2}, wherein N is the second number of bits (N_{LSC}).

8. The IMC device according to any one of the preceding claims, wherein the first computation window (CW₁) has a duration greater than or equal to the duration of the second computation window (CW₂).

9. The IMC device according to any one of the preceding claims, wherein the duration of the first and the second computation windows are a function of a reference duration (T_{R}) set by a user of the IMC device before the start of the first and the second computation windows.

10. The IMC device according to any one of the preceding claims, wherein the first computation weight (Gᵢⱼ) has a total number of bits (2N) greater than the first and the second number of bits (N_{MSC}, N_{LSC}) and comprises a group of most significant bits and a group of least significant bits, the first electrical quantity (R_{i,MSC}) being programmable in such a way as to be a function of the group of most significant bits of the first computation weight, the second electrical quantity (R_{i,LSC}) being programmable in such a way as to be a function of the group of least significant bits of the first computation weight.

11. The IMC device according to any one of the preceding claims, wherein the read circuit comprises an integrator (105) configured to detect a first number of charge packets starting from the first bit line current during the first computation window and update the first integration signal as a function of the first number of charge packets, and/or configured to detect a second number of charge packets starting from the second bit line current during the second computation window and update the second integration signal as a function of the second number of charge packets.

12. The IMC device according to any one of the preceding claims, wherein the first and/or the second integration signals (IN_{A}) are each indicative of a number of charge packets detected starting from the respective bit line current during the respective computation window, the read circuit comprising a counting stage (111) of the ripple-counter type configured to increase the digital signal (qᵢ) as a function of the number of charge packets detected both during the first computation window and during the second computation window and as a function of the at least one multiplication factor (P_{MSC}, P_{LSC}).

13. The IMC device according to any one of the preceding claims, wherein each of the first and the second memory cells comprise a respective current path comprising a variable-resistance storage element (25)and a selection element (26) and extending between a common node (28) and a reference potential node (29), the selection element of the first memory cell (MSC) and the second memory cell (LSC) being configured to selectively close the respective current path in response to the reception of the first activation signal (S_{j,MSC}) and, respectively, the second activation signal (S_{j,LSC}).

14. The IMC device according to any one of the preceding claims, wherein the first and the second memory cells are non-volatile memory cells, in particular based on phase-change material.

15. A method for controlling an in-memory computation device (10) comprising a memory array (12) including at least one group of memory cells (22_{i,j}) comprising a first memory cell (MSC) coupled to a first word line (WLⱼ) and a first bit line (BL_{i,MSC}), the first memory cell having a first number of bits (N_{MSC}) and being programmed to have a first electrical quantity (R_{i,MSC}, g_{i,MSC}) as a function of a first computation weight (Gᵢⱼ), and a second memory cell (LSC) coupled to a second word line (WLⱼ) and a second bit line (BL_{i,LSC}), the second memory cell having a second number of bits (N_{LSC}) and being programmed to have a second electrical quantity (R_{i,LSC}, g_{i,LSC}) as a function of the first computation weight;
the method comprising, by an activation circuit (14):
providing a first activation signal (S_{j,MSC}) to the first word line (WLⱼ) during a first computation window (CW₁), the first activation signal having a first duration (T_{j,MSC}) which is a function of a first input value (xⱼ), and
providing a second activation signal (S_{j,LSC}) to the second word line (WLⱼ) during a second computation window (CW₂) distinct from the first computation window, the second activation signal having a second duration (T_{j,LSC}) which is a function of the first input value,
wherein the first memory cell (MSC) is configured to be traversed, when activated during the first computation window (CW₁), by a first cell current (I_{MSC}) which is a function of the first electrical quantity (R_{MSC}) and the first activation duration (T_{j,MSC}), wherein the second memory cell (LSC) is configured to be traversed, when activated during the second computation window (CW₂), by a second cell current (I_{LSC}) which is a function of the second electrical quantity (R_{LSC}) and the second activation duration (T_{j,LSC}),
wherein the first bit line (BL_{i,MSC}) is configured to be traversed, during the first computation window (CW₁), by a first bit line current (I_{BLi,MSC}) which is a function of the first cell current (I_{MSC}) and wherein the second bit line (BL_{i,LSC}) is configured to be traversed, during the second computation window (CW₂), by a second bit line current (I_{BLi,LSC}) which is a function of the second cell current (I_{LSC}),
the method further comprising, by a read circuit (15):
generating a first integration signal (Q_{i,MSC}, IN_{A}) indicative of a time integral of the first bit line current during the first computation window;
generating a second integration signal (Q_{i,LSC}, IN_{A}) indicative of a time integral of the second bit line current during the second computation window,
providing a digital signal (qᵢ) indicative of a sum of the first and the second integration signals,
wherein the first activation duration (T_{j,MSC}) is different from the second activation duration (T_{j,LSC}) and at least one of the first activation duration (T_{j,MSC}) and the second activation duration (T_{j,LSC}) is also a function of at least one of the first number of bits (N_{MSC}) and the second number of bits (N_{LSC}); and/or
wherein providing the digital signal comprises multiplying at least one of the first integration signal and the second integration signal by at least one multiplication factor which is a function of at least one of the first and the second number of bits.

## Patentansprüche

1. In-Memory-Berechnungs, IMC,-Vorrichtung (10), umfassend:
ein Speicher-Array (12), das mindestens eine Gruppe von Speicherzellen (22_{i,j}) beinhaltet, die eine erste Speicherzelle (MSC) umfasst, die an eine erste Wortleitung (WLⱼ) und eine erste Bit-Leitung (BL_{i,MSC}) koppelbar ist, wobei die erste Speicherzelle eine erste Anzahl an Bits (N_{MSC}) aufweist und programmierbar ist, um eine erste elektrische Größe (R_{i,MSC}, g_{i,MSC}) in Abhängigkeit von einer ersten Berechnungsgewichtung (Gᵢⱼ) aufzuweisen, und eine zweite Speicherzelle (LSC), die an eine zweite Wortleitung (WLⱼ) und eine zweite Bit-Leitung (BL_{i,LSC}) koppelbar ist, wobei die zweite Speicherzelle eine zweite Anzahl an Bits (N_{LSC}) aufweist und programmierbar ist, um eine zweite elektrische Größe (Rᵢ,_{LSC}, gᵢ,_{LSC}) in Abhängigkeit von der ersten Berechnungsgewichtung aufzuweisen;
eine Aktivierungsschaltung (14), die konfiguriert ist, um der ersten Wortleitung (WLⱼ) während eines ersten Berechnungsfensters (CW₁) ein erstes Aktivierungssignal (S_{j,MSC}), und der zweiten Wortleitung (WLⱼ) während eines zweiten, vom ersten Berechnungsfenster verschiedenen Berechnungsfensters (CW₂) ein zweites Aktivierungssignal (S_{j,LSC}) bereitzustellen, wobei das erste Aktivierungssignal eine erste Dauer (T_{j,MSC}) aufweist, die von einem ersten Eingabewert (xⱼ) abhängig ist, und das zweite Aktivierungssignal eine zweite Dauer (T_{j,LSC}) aufweist, die vom ersten Eingabewert abhängig ist,
wobei die erste Speicherzelle (MSC) konfiguriert ist, um während des ersten Berechnungsfensters (CW₁) von einem ersten Zellstrom (I_{MSC}) durchflossen zu werden, der von der ersten elektrischen Größe (R_{MSC}) und der ersten Aktivierungsdauer (T_{j,MSC}) abhängig ist, wobei die zweite Speicherzelle (LSC) konfiguriert ist, um während des zweiten Berechnungsfensters von einem zweiten Zellstrom (I_{LSC}) durchflossen zu werden, der von der zweiten elektrischen Größe (R_{LSC}) und der zweiten Aktivierungsdauer (T_{j,LSC}) abhängig ist,
wobei die erste Bit-Leitung (BL_{i,MSC}) konfiguriert ist, um während des ersten Berechnungsfensters (CW₁) von einem ersten Bit-Leitungsstrom (I_{BLi,MSC}) durchflossen zu werden, der vom ersten Zellstrom (I_{MSC}) abhängig ist, und wobei die zweite Bit-Leitung (BL_{i,LSC}) konfiguriert ist, um während des zweiten Berechnungsfensters (CW₂) von einem zweiten Bit-Leitungsstrom (I_{BLi,LSC}) durchflossen zu werden, der vom zweiten Zellstrom (I_{LSC}) abhängig ist,
wobei die IMC-Vorrichtung weiter eine Leseschaltung (15) umfasst, die mit der ersten und der zweiten Bit-Leitung koppelbar ist und konfiguriert ist, um ein erstes Integrationssignal (Q_{i,MSC}, IN_{A}) zu erzeugen, das auf ein Zeitintegral des ersten Bit-Leitungsstroms während des ersten Berechnungsfensters hinweist, ein zweites Integrationssignal (Q_{i,LSC}, IN_{A}) zu erzeugen, das auf ein Zeitintegral des zweiten Bit-Leitungsstroms während des zweiten Berechnungsfensters hinweist, und ein digitales Signal (qᵢ) bereitzustellen, das auf eine Summe des ersten und zweiten Integrationssignals hinweist,
wobei sich die erste Aktivierungsdauer (T_{j,MSC}) von der zweiten Aktivierungsdauer (T_{j,LSC}) unterscheidet und mindestens eine von der ersten Aktivierungsdauer (T_{j,MSC}) und der zweiten Aktivierungsdauer (T_{j,LSC}) auch von mindestens einer von der ersten Anzahl an Bits (N_{MSC}) und der zweiten Anzahl an Bits (N_{LSC}) abhängig ist, und/oder die Leseschaltung (15) weiter konfiguriert ist, um mindestens eines von dem ersten Integrationssignal und dem zweiten Integrationssignal mit mindestens einem Multiplikationsfaktor (P_{MSC}, P_{LSC}) zu multiplizieren, der von mindestens einer von der ersten Anzahl an Bits und der zweiten Anzahl an Bits abhängig ist.

2. IMC-Vorrichtung nach dem vorstehenden Anspruch, wobei die erste Aktivierungsdauer (T_{j,MSC}) größer ist als die zweite Aktivierungsdauer (T_{j,LSC}) und ein Verhältnis (T_{j,MSC}/T_{j,LSC}) zwischen der ersten Aktivierungsdauer und der zweiten Aktivierungsdauer von der zweiten Anzahl an Bits (N_{LSC}) abhängig ist.

3. IMC-Vorrichtung nach Anspruch 1 oder 2, wobei mindestens eine von der ersten Aktivierungsdauer und der zweiten Aktivierungsdauer, insbesondere das Verhältnis zwischen der ersten Aktivierungsdauer und der zweiten Aktivierungsdauer von 2^{N} abhängig ist, wobei N die zweite Anzahl an Bits (N_{LSC}) ist.

4. IMC-Vorrichtung nach einem der vorstehenden Ansprüche, wobei die Leseschaltung (15) konfiguriert ist, um das erste Integrationssignal mit einem ersten Multiplikationsfaktor (P_{MSC}) und/oder das zweite Integrationssignal (Q_{i,LSC}) mit einem zweiten Multiplikationsfaktor (P_{LSC}) zu multiplizieren, wobei ein Verhältnis zwischen dem ersten und dem zweiten Multiplikationsfaktor (P_{MSC}/P_{LSC}) von der zweiten Anzahl an Bits (N_{LSC}) abhängig ist und größer als 1 ist.

5. IMC-Vorrichtung nach einem der vorstehenden Ansprüche, wobei der mindestens eine Multiplikationsfaktor (P_{MSC}, P_{LSC}), insbesondere das Verhältnis zwischen dem ersten und dem zweiten Multiplikationsfaktor, von 2^{N} abhängig ist, wobei N die zweite Anzahl an Bits (N_{LSC}) ist.

6. IMC-Vorrichtung nach einem der vorstehenden Ansprüche, wobei sich die erste Aktivierungsdauer (T_{j,MSC}) von der zweiten Aktivierungsdauer (T_{j,LSC}) unterscheidet und das Verhältnis zwischen der ersten und der zweiten Aktivierungsdauer von der zweiten Anzahl an Bits (N_{LSC}) abhängig ist, und wobei die Leseschaltung konfiguriert ist, um das erste Integrationssignal (Q_{i,MSC}) mit einem ersten Multiplikationsfaktor (P_{MSC}) und das zweite Integrationssignal (Q_{i,LSC}) mit einem zweiten, vom ersten Multiplikationsfaktor verschiedenen Multiplikationsfaktor (P_{LSC}) zu multiplizieren, wobei das Verhältnis zwischen dem ersten Multiplikationsfaktor und dem zweiten Multiplikationsfaktor von der zweiten Anzahl an Bits abhängig ist.

7. IMC-Vorrichtung nach dem vorstehenden Anspruch, wobei das Verhältnis zwischen der ersten und der zweiten Aktivierungsdauer und das Verhältnis zwischen dem ersten und dem zweiten Multiplikationsfaktor jeweils von 2^{N/2} abhängig sind, wobei N die zweite Anzahl an Bits (N_{LSC}) ist.

8. IMC-Vorrichtung nach einem der vorstehenden Ansprüche, wobei das erste Berechnungsfenster (CW₁) eine Dauer aufweist, die größer oder gleich der Dauer des zweiten Berechnungsfensters (CW₂) ist.

9. IMC-Vorrichtung nach einem der vorstehenden Ansprüche, wobei die Dauer des ersten und des zweiten Berechnungsfensters von einer Referenzdauer (T_{R}) abhängig ist, die von einem Benutzer der IMC-Vorrichtung vor Beginn des ersten und des zweiten Berechnungsfensters festgelegt wird.

10. IMC-Vorrichtung nach einem der vorstehenden Ansprüche, wobei die erste Berechnungsgewichtung (Gᵢⱼ) eine Gesamtanzahl an Bits (2N) aufweist, die größer ist als die erste und die zweite Anzahl an Bits (N_{MSC}, N_{LSC}), und eine Gruppe von höchstwertigen Bits und eine Gruppe von niedrigstwertigen Bits umfasst, wobei die erste elektrische Größe (R_{i,MSC}) programmierbar ist, um von der Gruppe der höchstwertigen Bits der ersten Berechnungsgewichtung abhängig zu sein, und die zweite elektrische Größe (R_{i,LSC}) programmierbar ist, um von der Gruppe der niedrigstwertigen Bits der ersten Berechnungsgewichtung abhängig zu sein.

11. IMC-Vorrichtung nach einem der vorstehenden Ansprüche, wobei die Leseschaltung einen Integrator (105) umfasst, der konfiguriert ist, um eine erste Anzahl an Ladungspaketen ausgehend vom ersten Bit-Leitungsstrom während des ersten Berechnungsfensters zu erkennen und das erste Integrationssignal in Abhängigkeit von der ersten Anzahl an Ladungspaketen zu aktualisieren, und/oder konfiguriert ist, um eine zweite Anzahl an Ladungspaketen ausgehend vom zweiten Bit-Leitungsstrom während des zweiten Berechnungsfensters zu erkennen und das zweite Integrationssignal in Abhängigkeit von der zweiten Anzahl an Ladungspaketen zu aktualisieren.

12. IMC-Vorrichtung nach einem der vorstehenden Ansprüche, wobei die ersten und/oder die zweiten Integrationssignale (IN_{A}) jeweils auf eine Anzahl an Ladungspaketen hinweisen, die ausgehend von dem jeweiligen Bit-Leitungsstrom während des jeweiligen Berechnungsfensters erkannt werden, wobei die Leseschaltung eine Zählstufe (111) vom Ripple-Counter-Typ umfasst, die konfiguriert ist, um das digitale Signal (qᵢ) in Abhängigkeit von der Anzahl der während des ersten Berechnungsfensters und während des zweiten Berechnungsfensters erkannten Ladungspakete und in Abhängigkeit von dem mindestens einen Multiplikationsfaktor (P_{MSC}, P_{LSC}) zu erhöhen.

13. IMC-Vorrichtung nach einem der vorstehenden Ansprüche, wobei jede der ersten und der zweiten Speicherzellen jeweils einen jeweiligen Strompfad umfasst, der ein Speicherelement mit variablem Widerstand (25) und ein Auswahlelement (26) umfasst und sich zwischen einem gemeinsamen Knoten (28) und einem Referenzpotentialknoten (29) erstreckt, wobei das Auswahlelement der ersten Speicherzelle (MSC) und der zweiten Speicherzelle (LSC) konfiguriert ist, um den jeweiligen Strompfad als Reaktion auf den Empfang des ersten Aktivierungssignals (S_{j,MSC}) bzw. des zweiten Aktivierungssignals (S_{j,LSC}) selektiv zu schließen.

14. IMC-Vorrichtung gemäß einem der vorstehenden Ansprüche, wobei die erste und die zweite Speicherzelle nichtflüchtige Speicherzellen, insbesondere basierend auf Phasenwechselmaterial sind.

15. Verfahren zur Steuerung einer In-Memory-Berechnungsvorrichtung (10), die ein Speicher-Array (12) umfasst, das mindestens eine Gruppe von Speicherzellen (22_{i,j}) beinhaltet, umfassend eine erste Speicherzelle (MSC), die mit einer ersten Wortleitung (WLⱼ) und einer ersten Bit-Leitung (BL_{i,MSC}) gekoppelt ist, wobei die erste Speicherzelle eine erste Anzahl an Bits (N_{MSC}) aufweist und programmiert ist, um eine erste elektrische Größe (R_{i,MSC}, g_{i,MSC}) in Abhängigkeit von einer ersten Berechnungsgewichtung (Gᵢⱼ) aufzuweisen, und eine zweite Speicherzelle (LSC), die mit einer zweiten Wortleitung (WLⱼ) und einer zweiten Bit-Leitung (BL_{i,LSC}) gekoppelt ist, wobei die zweite Speicherzelle eine zweite Anzahl an Bits (N_{LSC}) aufweist und programmiert ist, um eine zweite elektrische Größe (R_{i,LSC}, g_{i,LSC}) in Abhängigkeit von der ersten Berechnungsgewichtung aufzuweisen;
wobei das Verfahren, durch eine Aktivierungsschaltung (14) umfasst:
Bereitstellen eines ersten Aktivierungssignals (S_{j,MSC}) für die erste Wortleitung (WLⱼ) während eines ersten Berechnungsfensters (CW₁), wobei das erste Aktivierungssignal eine erste Dauer (T_{j,MSC}) aufweist, die von einem ersten Eingabewert (xⱼ) abhängig ist, und
Bereitstellen eines zweiten Aktivierungssignals (S_{j,LSC}) für die zweite Wortleitung (WLⱼ) während eines zweiten Berechnungsfensters (CW₂), das sich vom ersten Berechnungsfenster unterscheidet, wobei das zweite Aktivierungssignal eine zweite Dauer (T_{j,LSC}) aufweist, die von dem ersten Eingabewert abhängig ist,
wobei die erste Speicherzelle (MSC) konfiguriert ist, um, wenn sie während des ersten Berechnungsfensters (CW₁) aktiviert wird, von einem ersten Zellstrom (I_{MSC}) durchflossen zu werden, der von der ersten elektrischen Größe (R_{MSC}) und der ersten Aktivierungsdauer (T_{j,MSC}) abhängig ist, wobei die zweite Speicherzelle (LSC) konfiguriert ist, um, wenn sie während des zweiten Berechnungsfensters (CW₂) aktiviert wird, von einem zweiten Zellstrom (I_{LSC}) durchflossen zu werden, der von der zweiten elektrischen Größe (R_{LSC}) und der zweiten Aktivierungsdauer (T_{j,LSC}) abhängig ist,
wobei die erste Bit-Leitung (BL_{i,MSC}) konfiguriert ist, um während des ersten Berechnungsfensters (CW₁) von einem ersten Bit-Leitungsstrom (I_{BLi,MSC}) durchflossen zu werden, der vom ersten Zellstrom (I_{MSC}) abhängig ist, und wobei die zweite Bit-Leitung (BL_{i,LSC}) konfiguriert ist, um während des zweiten Berechnungsfensters (CW₂) von einem zweiten Bit-Leitungsstrom (I_{BLi,LSC}) durchflossen zu werden, der vom zweiten Zellstrom (I_{LSC}) abhängig ist,
wobei das Verfahren weiter durch eine Leseschaltung (15) umfasst:
Erzeugen eines ersten Integrationssignals (Q_{i,MSC}, IN_{A}), das auf ein Zeitintegral des ersten Bit-Leitungsstroms während des ersten Berechnungsfensters hinweist;
Erzeugen eines zweiten Integrationssignals (Q_{i,LSC}, IN_{A}) das auf ein Zeitintegral des zweiten Bit-Leitungsstroms während des zweiten Berechnungsfensters hinweist;
Bereitstellen eines digitalen Signals (qᵢ), das auf eine Summe des ersten und des zweiten Integrationssignals hinweist,
wobei sich die erste Aktivierungsdauer (T_{j,MSC}) von der zweiten Aktivierungsdauer (T_{j,LSC}) unterscheidet und mindestens eine von der ersten Aktivierungsdauer (T_{j,MSC}) und der zweiten Aktivierungsdauer (T_{j,LSC}) auch von mindestens einer der ersten Anzahl an Bits (N_{MSC}) und der zweiten Anzahl an Bits (N_{LSC}) abhängig ist; und/oder
wobei das Bereitstellen des digitalen Signals das Multiplizieren von mindestens einem des ersten Integrationssignals und des zweiten Integrationssignals mit mindestens einem Multiplikationsfaktor umfasst, der von mindestens einer der ersten und der zweiten Anzahl an Bits abhängig ist.

## Revendications

1. Dispositif de calcul en mémoire, ou IMC, (10) comprenant :
une matrice mémoire (12) comportant au moins un groupe de cellules de mémoire (22_{i,j}) comprenant une première cellule de mémoire (MSC) pouvant être couplée à une première ligne de mot (WLⱼ) et à une première ligne binaire (BL_{i,MSC}), la première cellule de mémoire ayant un premier nombre de bits (N_{MSC}) et étant programmable pour avoir une première quantité électrique (R_{i,MSC}, g_{i,MSC}) en fonction d'un premier poids de calcul (Gᵢⱼ), et une deuxième cellule de mémoire (LSC) pouvant être couplée à une deuxième ligne de mot (WLⱼ) et à une deuxième ligne binaire (BL_{i,LSC}), la deuxième cellule de mémoire ayant un deuxième nombre de bits (N_{LSC}) et étant programmable pour avoir une deuxième quantité électrique (R_{i,LSC}, g_{i,LSC}) en fonction du premier poids de calcul ;
un circuit d'activation (14) configuré pour fournir un premier signal d'activation (S_{j,MSC}) à la première ligne de mot (WLⱼ) au cours d'une première fenêtre de calcul (CW₁) et un deuxième signal d'activation (S_{j,LSC}) à la deuxième ligne de mot (WLⱼ) au cours d'une deuxième fenêtre de calcul (CW₂) distincte de la première fenêtre de calcul, le premier signal d'activation ayant une première durée (T_{j,MSC}) qui est fonction d'une première valeur d'entrée (xⱼ), le deuxième signal d'activation ayant une deuxième durée (T_{j,LSC}) qui est fonction de la première valeur d'entrée,
dans lequel la première cellule de mémoire (MSC) est configurée pour être traversée, pendant la première fenêtre de calcul (CW₁), par un premier courant de cellule (I_{MSC}) qui est fonction de la première quantité électrique (R_{MSC}) et de la première durée d'activation (T_{j,MSC}), dans lequel la deuxième cellule de mémoire (LSC) est configurée pour être traversée, pendant la deuxième fenêtre de calcul, par un deuxième courant de cellule (I_{LSC}) qui est fonction de la deuxième quantité électrique (R_{LSC}) et de la deuxième durée d'activation (T_{j,LSC}),
dans lequel la première ligne binaire (BL_{i,MSC}) est configurée pour être traversée, pendant la première fenêtre de calcul (CW₁), par un premier courant de ligne binaire (I_{BLi,MSC}) qui est fonction du premier courant de cellule (I_{MSC}) et dans lequel la deuxième ligne binaire (BL_{i,LSC}) est configurée pour être traversée, pendant la deuxième fenêtre de calcul (CW₂), par un deuxième courant de ligne binaire (I_{BLi,LSC}) qui est fonction du deuxième courant de cellule (I_{LSC}),
le dispositif IMC comprenant en outre un circuit de lecture (15) pouvant être couplé aux première et deuxième lignes binaires et configuré pour produire un premier signal d'intégration (Q_{i,MSC}, IN_{A}) représentant une intégrale par rapport au temps du premier courant de ligne binaire pendant la première fenêtre de calcul, produire un deuxième signal d'intégration (Q_{i,LSC}, IN_{A}) représentant une intégrale par rapport au temps du deuxième courant de ligne binaire pendant la deuxième fenêtre de calcul, et fournir un signal numérique (qᵢ) représentant une somme des premier et deuxième signaux d'intégration,
dans lequel la première durée d'activation (T_{j,MSC}) est différente de la deuxième durée d'activation (T_{j,LSC}) et au moins l'une des première durée d'activation (T_{j,MSC}) et deuxième durée d'activation (T_{j,LSC}) est aussi fonction d'au moins l'un des premier nombre de bits (N_{MSC}) et deuxième nombre de bits (N_{LSC}), et/ou le circuit de lecture (15) est configuré en outre pour multiplier au moins l'un des premier signal d'intégration et deuxième signal d'intégration d'au moins un facteur de multiplication (P_{MSC}, P_{LSC}) qui est fonction d'au moins l'un des premier nombre de bits et deuxième nombre de bits.

2. Dispositif IMC selon la revendication précédente, dans lequel la première durée d'activation (T_{j,MSC}) est supérieure à la deuxième durée d'activation (T_{j,LSC}) et un rapport (T_{j,MSC}/ T_{j,LSC}) entre la première durée d'activation et la deuxième durée d'activation est fonction du deuxième nombre de bits (N_{LSC}).

3. Dispositif IMC selon la revendication 1 ou 2, dans lequel au moins l'une des première durée d'activation et deuxième durée d'activation, en particulier le rapport entre la première durée d'activation et la deuxième durée d'activation, est fonction de 2^{N}, où N est le deuxième nombre de bits (N_{LSC}).

4. Dispositif IMC selon l'une quelconque des revendications précédentes, dans lequel le circuit de lecture (15) est configuré pour multiplier le premier signal d'intégration par un premier facteur de multiplication (P_{MSC}) et/ou le deuxième signal d'intégration (Q_{i,LSC}) par un deuxième facteur de multiplication (P_{LSC}), dans lequel un rapport entre les premier et deuxième facteurs de multiplication (P_{MSC}/P_{LSC}) est fonction du deuxième nombre de bits (N_{LSC}) et est supérieur à 1.

5. Dispositif IMC selon l'une quelconque des revendications précédentes, dans lequel ledit au moins un facteur de multiplication (P_{MSC}, P_{LSC}), en particulier le rapport entre les premier et deuxième facteurs de multiplication, est fonction de 2^{N}, où N est le deuxième nombre de bits (N_{LSC}).

6. Dispositif IMC selon l'une quelconque des revendications précédentes, dans lequel la première durée d'activation (T_{j,MSC}) est différente de la deuxième durée d'activation (T_{j,LSC}) et le rapport entre les première et deuxième durées d'activation est fonction du deuxième nombre de bits (N_{LSC}), et dans lequel le circuit de lecture est configuré pour multiplier le premier signal d'intégration (Q_{i,MSC}) par un premier facteur de multiplication (P_{MSC}) et le deuxième signal d'intégration (Q_{i,LSC}) par un deuxième facteur de multiplication (P_{LSC}) différent du premier facteur de multiplication et le rapport entre le premier facteur de multiplication et le deuxième facteur de multiplication est fonction du deuxième nombre de bits.

7. Dispositif IMC selon la revendication précédente, dans lequel le rapport entre les première et deuxième durées d'activation et le rapport entre les premier et deuxième facteurs de multiplication sont tous deux fonction de 2^{N/2}, où N est le deuxième nombre de bits (N_{LSC}).

8. Dispositif IMC selon l'une quelconque des revendications précédentes, dans lequel la première fenêtre de calcul (CW₁) a une durée supérieure ou égale à la durée de la deuxième fenêtre de calcul (CW₂).

9. Dispositif IMC selon l'une quelconque des revendications précédentes, dans lequel la durée des première et deuxième fenêtres de calcul est fonction d'une durée de référence (T_{R}) établie par un utilisateur du dispositif IMC avant le début des première et deuxième fenêtres de calcul.

10. Dispositif IMC selon l'une quelconque des revendications précédentes, dans lequel le premier poids de calcul (Gᵢⱼ) a un nombre total de bits (2N) supérieur aux premier et deuxième nombres de bits (N_{MSC}, N_{LSC}) et comprend un groupe de bits de poids fort et un groupe de bits de poids faible, la première quantité électrique (R_{i,MSC}) étant programmable de manière à être fonction du groupe de bits de poids fort du premier poids de calcul, la deuxième quantité électrique (R_{i,LSC}) étant programmable de manière à être fonction du groupe de bits de poids faible du premier poids de calcul.

11. Dispositif IMC selon l'une quelconque des revendications précédentes, dans lequel le circuit de lecture comprend un intégrateur (105) configuré pour détecter un premier nombre de paquets de charge commençant au premier courant de ligne binaire pendant la première fenêtre de calcul et pour actualiser le premier signal d'intégration en fonction du premier nombre de paquets de charge, et/ou configuré pour détecter un deuxième nombre de paquets de charge commençant au deuxième courant de ligne binaire pendant la deuxième fenêtre de calcul et pour actualiser le deuxième signal d'intégration en fonction du deuxième nombre de paquets de charge.

12. Dispositif IMC selon l'une quelconque des revendications précédentes, dans lequel le premier et/ou le deuxième signal d'intégration (IN_{A}) représente un nombre de paquets de charge détectés à partir du courant de ligne binaire respectif pendant la fenêtre de calcul respective, le circuit de lecture comprenant un étage de comptage (111) du type compteur en cascade configuré pour augmenter le signal numérique (qᵢ) en fonction du nombre de paquets de charge détectés pendant la première fenêtre de calcul et pendant la deuxième fenêtre de calcul et en fonction dudit au moins un facteur de multiplication (P_{MSC}, P_{LSC}).

13. Dispositif IMC selon l'une quelconque des revendications précédentes, dans lequel chacune des première et deuxième cellules de mémoire comprend un chemin de courant respectif comprenant un élément de stockage à résistance variable (25) et un élément de sélection (26) et s'étendant entre un nœud commun (28) et un nœud de potentiel de référence (29), l'élément de sélection de la première cellule de mémoire (MSC) et de la deuxième cellule de mémoire (LSC) étant configuré pour fermer sélectivement le chemin de courant respectif en réponse à la réception du premier signal d'activation (S_{j,MSC}) et, respectivement, du deuxième signal d'activation (S_{j,LSC}).

14. Dispositif IMC selon l'une quelconque des revendications précédentes, dans lequel les première et deuxième cellules de mémoire sont des cellules de mémoire non volatile, en particulier basées sur un matériau à changement de phase.

15. Procédé de commande d'un dispositif de calcul en mémoire (10) comprenant une matrice mémoire (12) comportant au moins un groupe de cellules de mémoire (22_{i,j}) comprenant une première cellule de mémoire (MSC) couplée à une première ligne de mot (WLⱼ) et à une première ligne binaire (BL_{i,MSC}), la première cellule de mémoire ayant un premier nombre de bits (N_{MSC}) et étant programmée pour avoir une première quantité électrique (R_{i,MSC}, g_{i,MSC}) en fonction d'un premier poids de calcul (Gᵢⱼ), et une deuxième cellule de mémoire (LSC) couplée à une deuxième ligne de mot (WLⱼ) et à une deuxième ligne binaire (BL_{i,LSC}), la deuxième cellule de mémoire ayant un deuxième nombre de bits (N_{LSC}) et étant programmée pour avoir une deuxième quantité électrique (R_{i,LSC}, g_{i,LSC}) en fonction du premier poids de calcul ;
le procédé comprenant les étapes suivantes, exécutées par un circuit d'activation (14) :
fournir un premier signal d'activation (S_{j,MSC}) à la première ligne de mot (WLⱼ) au cours d'une première fenêtre de calcul (CW₁), le premier signal d'activation ayant une première durée (T_{j,MSC}) qui est fonction d'une première valeur d'entrée (xⱼ), et
fournir un deuxième signal d'activation (S_{j,LSC}) à la deuxième ligne de mot (WLⱼ) au cours d'une deuxième fenêtre de calcul (CW₂) distincte de la première fenêtre de calcul, le deuxième signal d'activation ayant une deuxième durée (T_{j,LSC}) qui est fonction de la première valeur d'entrée,
dans lequel la première cellule de mémoire (MSC) est configurée pour être traversée, quand elle est activée pendant la première fenêtre de calcul (CW₁), par un premier courant de cellule (I_{MSC}) qui est fonction de la première quantité électrique (R_{MSC}) et de la première durée d'activation (T_{j,MSC}), dans lequel la deuxième cellule de mémoire (LSC) est configurée pour être traversée, quand elle est activée pendant la deuxième fenêtre de calcul (CW₂), par un deuxième courant de cellule (I_{LSC}) qui est fonction de la deuxième quantité électrique (R_{LSC}) et de la deuxième durée d'activation (T_{j,LSC}),
dans lequel la première ligne binaire (BL_{i,MSC}) est configurée pour être traversée, pendant la première fenêtre de calcul (CW₁), par un premier courant de ligne binaire (I_{BLi,MSC}) qui est fonction du premier courant de cellule (I_{MSC}) et dans lequel la deuxième ligne binaire (BL_{i,LSC}) est configurée pour être traversée, pendant la deuxième fenêtre de calcul (CW₂), par un deuxième courant de ligne binaire (I_{BLi,LSC}) qui est fonction du deuxième courant de cellule (I_{LSC}),
le procédé comprenant en outre les étapes suivantes, exécutées par un circuit de lecture (15) :
produire un premier signal d'intégration (Q_{i,MSC}, IN_{A}) représentant une intégrale par rapport au temps du premier courant de ligne binaire pendant la première fenêtre de calcul ;
produire un deuxième signal d'intégration (Q_{i,LSC}, IN_{A}) représentant une intégrale par rapport au temps du deuxième courant de ligne binaire pendant la deuxième fenêtre de calcul,
fournir un signal numérique (qᵢ) représentant une somme des premier et deuxième signaux d'intégration,
dans lequel la première durée d'activation (T_{j,MSC}) est différente de la deuxième durée d'activation (T_{j,LSC}) et au moins l'une des première durée d'activation (T_{j,MSC}) et deuxième durée d'activation (T_{j,LSC}) est aussi fonction d'au moins l'un des premier nombre de bits (N_{MSC}) et deuxième nombre de bits (N_{LSC}) ; et/ou
dans lequel la fourniture du signal numérique comprend le fait de multiplier au moins l'un des premier signal d'intégration et deuxième signal d'intégration par au moins un facteur de multiplication qui est fonction d'au moins l'un des premier et deuxième nombres de bits.
